# EUROPEAN PATENT SPECIFICATION

(11) **EP 3 681 035 B1**
(45) Date of publication and mention of the grant of the patent: **26.08.2026**
(21) Application number: 17924438.9
(22) Date of filing: 05.09.2017
(51) Int. Cl.: H02P 29/024, H02P 23/00, G01R 31/34

(54) **AC ELECTRIC MOTOR MONITORING DEVICE AND MONITORING METHOD, AND ELECTRIC MOTOR DRIVE SYSTEM MONITORING DEVICE AND MONITORING METHOD**
WECHSELSTROMELEKTROMOTORÜBERWACHUNGSVORRICHTUNG UND ÜBERWACHUNGSVERFAHREN UND ELEKTROMOTORANSTEUERUNGSSYSTEMÜBERWACHUNGSVORRICHTUNG UND ÜBERWACHUNGSVERFAHREN
DISPOSITIF DE CONTRÔLE ET PROCÉDÉ DE CONTRÔLE DE MOTEUR ÉLECTRIQUE À COURANT ALTERNATIF, ET DISPOSITIF DE CONTRÔLE ET PROCÉDÉ DE CONTRÔLE DE SYSTÈME D'ENTRAÎNEMENT DE MOTEUR ÉLECTRIQUE

(43) Date of publication of application: 15.07.2020
(73) Proprietor: Hitachi, Ltd., Tokyo 100-8280 (JP)
(72) Inventor: IWAJI, Yoshitaka, Tokyo 100-8280 (JP); ZHOU, Guangbin, Tokyo 100-8280 (JP); NAKAMURA, Akihiro, Tokyo 100-8280 (JP); TAKAHASHI, Akeshi, Tokyo 100-8280 (JP)
(74) Representative: Mewburn Ellis LLP
(86) International application number: PCT/JP2017/031886
(87) International publication number: WO 2019/049188

(56) References cited:
- EP-A1- 2 372 900
- WO-A1-2010/100998
- JP-A- 2005 049 178
- JP-A- 2007 118 680
- JP-A- 2010 158 089
- JP-A- 2011 147 317
- JP-A- 2013 121 202
- AKIN B ET AL: "DSP-Based Sensorless Electric Motor Fault Diagnosis Tools for Electric and Hybrid Electric Vehicle Powertrain Applications", IEEE TRANSACTIONS ON VEHICULAR TECHNOLOGY, IEEE SERVICE CENTER, PISCATAWAY, NJ, US, vol. 58, no. 5, 1 June 2009 (2009-06-01), pages 2150 - 2159, XP011248742, ISSN: 0018-9545
- AYDIN I ET AL: "A Simple and Efficient Method for Fault Diagnosis Using Time Series Data Mining", ELECTRIC MACHINES&DRIVES CONFERENCE, 2007. IEMDC '07. IEEE INTERNATIONAL, IEEE, PISCATAWAY, NJ, USA, 1 May 2007 (2007-05-01), pages 596 - 600, XP031114903, ISBN: 978-1-4244-0742-2
- SHNIBHA R A ET AL: "Smart Technique for Induction Motors Diagnosis by Monitoring the Power Factor Using Only the Measured Current", JOURNAL OF PHYSICS: CONFERENCE SERIES, INSTITUTE OF PHYSICS PUBLISHING, BRISTOL, GB, vol. 364, no. 1, 28 May 2012 (2012-05-28), pages 12062, XP020223144, ISSN: 1742-6596, DOI: 10.1088/1742-6596/364/1/012062

## Description

### Technical Field

The present invention relates to a monitoring device and monitoring method for an AC electric motor, and a monitoring device and monitoring method for an electric motor drive system.

### Background Art

In the fields of industry, consumer electronics, transportation, etc., a control microprocessor used in a product has been made faster in speed and made higher in performance. At the same time, information communication by a network has also developed rapidly. As these results, IoT (Internet of Things) being the effort to connect things to the network and thereby make good use of huge information has been attracting attention. In the case of the industrial field, many sensors are placed in a machine tool or the like, and their information are analyzed to thereby improve the productivity of a manufacturing process and quickly detect an abnormality of the machine tool to help maintenance work. The maintenance work of a device is shifting from the monitoring operation based on the conventional operation time to the work based on state monitoring based on the sensor signal.

There is a tendency that in order to perform monitoring of the device using the electric motor, current sensors are newly attached or sensors for temperature and vibration or the like are attached to the electric motor, and they are sampled in a constant cycle, and the resulting data is analyzed to perform state monitoring.

In Patent Literature 1, there has been shown a monitoring and optimization technique regarding the minimization of power consumption with an air-conditioning system as a target. At that time, environmental information are collected from many sensors to perform their analysis.

In Patent Literature 2 and Patent Literature 3, there has been disclosed a technique of power-spectrum analyzing a phase current of an induction electric motor or a terminal voltage to detect an abnormality from the amount of generation of its sideband.

As shown in these known examples, an AC electric motor has been used for a power source for various applications. The monitoring of the entire system by observing the behaviors of these AC electric motors is expected to be increasingly important in future.

### Citation List

### Patent Literature

Patent Literature 1: Japanese Patent Application Laid-Open No. 2015-1346
Patent Literature 2: Japanese Patent Application Laid-Open No. 2016-195524
Patent Literature 3: Japanese Patent Application Laid-Open No. 2016-197040
Patent Literature 4: European Patent Publication No. EP 2372900 A1

### Publications

Publication 1: AKIN B ET AL: "DSP-Based Sensorless Electric Motor Fault Diagnosis Tools for Electric and Hybrid Electric Vehicle Powertrain Applications", IEEE TRANSACTIONS ON VEHICULAR TECHNOLOGY, IEEE SERVICE CENTER, PISCATAWAY, NJ, US, vol. 58, no. 5, 1 June 2009 (2009-06-01), pages 2150-2159, XP011248742, ISSN: 0018-9545
Publication 2: AYDIN I ET AL: "A Simple and Efficient Method for Fault Diagnosis Using Time Series Data Mining", ELECTRIC MACHINES&DRIVES CONFERENCE, 2007. IEMDC '07. IEEE INTERNATIONAL, IEEE, PISCATAWAY, NJ, USA, 1 May 2007 (2007-05-01), pages 596-600, XP031114903, ISBN: 978-1-4244-07 42-2
Publication 3: SHNIBHA RA ET AL: "Smart Technique for Induction Motors Diagnosis by Monitoring the Power Factor Using Only the Measured Current", JOURNAL OF PHYSICS: CONFERENCE SERIES, INSTITUTE OF PHYSICS PUBLISHING, BRISTOL, GB, vol. 364, no. 1, 28 May 2012 (2012-05-28), page 12062, XP020223144, ISSN: 1742-6596, DOI: 10.1088/1742-6596/364/1/012062. The document EP2372900A1 discloses a control system for an electric motor to which electric power is supplied from a DC power supply via a multi-phase inverter.

### Summary of Invention

### Technical Problem

As shown in Patent Literature 1, it is possible to obtain a lot of information by arranging a large number of environmental sensors. There is however a tendency that the number of sensors is increased so that the number of data is also increased, and eventually, the enormous time is required for analysis after data acquisition.

Further, a current detection value becomes an AC amount because the AC electric motor is used. It is therefore necessary to sufficiently make a sampling period in data collection sufficiently shorter than the period of the alternating current in principle. For that reason, the amount of data is increased, and further, data processing at the analyzing time also takes time.

In Patent Literatures 2 and 3, the state monitoring has been performed using the power spectrum of the current of the induction electric motor. In this method, if there exists an abnormality that occurs steadily (sustainedly), it is possible to detect the abnormality, but it is difficult to detect the sign of abnormality that appears only at a transient time such as at the time of a load fluctuation. Further, in the industrial equipment or the like, there are many applications which variable-speed drive an AC electric motor by an inverter. In such applications that a variable speed operation is repeated, it is difficult to detect an abnormality from the power spectrum. Patent Literature 4 proposes a control system for an electric motor comprising a phase current detection unit, a DC component acquiring unit, and a short-circuiting determination unit. Publication 1 proposes a signal processing-based motor fault diagnosis scheme for testing rotor asymmetry at zero speed. Publication 2 proposes a classification bases technique based on time series data mining for detecting broken rotor bar faults in induction motors. Publication 3 proposes a technique for induction motors diagnosis by monitoring a power factor using only a measured current.

### Solution to Problem

The feature of the present invention for solving the above problems is provided in a monitoring device according to claim 1.

### Advantageous Effects of Invention

An effect obtained by a representative among the inventions disclosed in the present application will be briefly described as follows.

According to the present invention, it is possible to greatly reduce the amount of data by treating a current flowing through an AC electric motor as a DC amount. Further, by converting AC into DC by a simple algorithm, edge processing for determining an abnormality can be performed in a monitoring device. Problems, configurations, and effects other than those described above will be clarified by the following description of embodiments.

### Brief Description of Drawings

Fig. 1 is a diagram showing the configuration of an electric motor drive system, an AC electric motor, and their monitoring device according to a first embodiment.
Fig. 2 is a diagram showing operation waveforms according to the first embodiment.
Fig. 3 is a diagram showing the configuration of an electric motor drive system, an AC electric motor, and their monitoring device according to a reference example.
Fig. 4 is a diagram showing operation waveforms according to the reference example.
Fig. 5 is a diagram showing the configuration of an electric motor drive system, an AC electric motor, and their monitoring device according to a second embodiment.
Fig. 6 is a diagram showing operation waveforms according to the second embodiment.
Fig. 7 is a diagram showing the configuration of an electric motor drive system, an AC electric motor, and their monitoring device according to a third embodiment.
Fig. 8 is a diagram showing operation waveforms according to the third embodiment.
Fig. 9 is a diagram showing the configuration of an electric motor drive system, an AC electric motor, and their monitoring device according to a fourth embodiment.
Fig. 10 is a diagram showing operation waveforms according to the fourth embodiment.
Fig. 11 is a diagram showing the configuration of an electric motor drive system, an AC electric motor, and their monitoring device according to a fifth embodiment.
Fig. 12 is a diagram showing operation waveforms according to the fifth embodiment.
Fig. 13 is a diagram showing the configuration of an electric motor drive system, an AC electric motor, and their monitoring device according to a sixth embodiment.
Fig. 14 is a diagram showing the configuration of a feature extractor according to a seventh embodiment.
Fig. 15 is a diagram showing operation waveforms according to the seventh embodiment.
Fig. 16 is a diagram showing the configuration of a feature extractor according to an eighth embodiment.
Fig. 17 is a diagram showing the configuration of a feature extractor according to a ninth embodiment.
Fig. 18 is a diagram showing operation waveforms according to the ninth embodiment.
Fig. 19 is a diagram showing the configuration of another feature extractor according to the ninth embodiment.
Fig. 20 is a diagram showing the configuration of an electric motor drive system, an AC electric motor, and their monitoring device according to a tenth embodiment.
Fig. 21 is a diagram showing the configuration of a feature extractor according to the tenth embodiment.
Fig. 22 is a diagram showing operation waveforms according to the tenth embodiment.
Fig. 23 is a diagram showing the configuration of an electric motor drive system, an AC electric motor, and their monitoring device according to an eleventh embodiment.
Fig. 24 is a diagram showing operation waveforms according to the eleventh embodiment.
Fig. 25 is a diagram showing the configuration of an electric motor drive system, an AC electric motor, and their monitoring device according to a twelfth embodiment.
Fig. 26 is a diagram showing a physical model of an electric motor/machine device according to the twelfth embodiment.
Fig. 27 is a diagram showing a state observer according to the twelfth embodiment.
Fig. 28 is a diagram showing the configuration of an electric motor drive system, an AC electric motor, and their monitoring device according to a thirteenth embodiment.
Fig. 29 is a diagram showing the configuration of a conduction ratio converter according to the thirteenth embodiment.
Fig. 30 is a diagram showing the configuration of a current allocator according to the thirteenth embodiment.
Fig. 31 is a diagram showing an operation of a switching element according to the thirteenth embodiment.
Fig. 32 is a diagram showing the configuration of a feature extractor according to the thirteenth embodiment.
Fig. 33 is a diagram showing operation waveforms according to the thirteenth embodiment.
Fig. 34 is a diagram showing the configuration of a feature extractor according to a fourteenth embodiment.
Fig. 35 is a diagram showing operation waveforms according to the fourteenth embodiment.
Fig. 36 is a diagram showing the configuration of an electric motor drive system, an AC electric motor, and their monitoring device according to a fifteenth embodiment.
Fig. 37 is a diagram showing the configuration of an electric motor drive system, an AC electric motor, and their monitoring device according to a sixteenth embodiment.
Fig. 38 is a diagram showing the configuration of an electric motor drive system, an AC electric motor, and their monitoring device according to a seventeenth embodiment.
Fig. 39 is a diagram showing the configuration of an electric motor drive system, an AC electric motor, and their monitoring device according to an eighteenth embodiment.
Fig. 40 is a diagram showing the configuration of an electric motor drive system, an AC electric motor, and their monitoring device according to a nineteenth embodiment.
Fig. 41 is a diagram showing the configuration of a current controller according to the nineteenth embodiment.
Fig. 42 is a diagram showing the configuration of an electric motor drive system, an AC electric motor, and their monitoring device according to the nineteenth embodiment.
Fig. 43 is a diagram showing the configuration of an electric motor drive system, an AC electric motor, and their monitoring device according to the nineteenth embodiment.
Fig. 44 is a diagram showing the configuration of a machine tool device and a monitoring device according to a twentieth embodiment.
Fig. 45 is a diagram showing the configuration of an electric vehicle and a monitoring device according to a twenty-first embodiment.
Fig. 46 is a diagram showing the configuration of an electric rail vehicle and a monitoring device according to a twenty-second embodiment.
Fig. 47 is a diagram showing the configuration of an air conditioner outdoor unit and a monitoring device according to a twenty-third embodiment.

### Description of Embodiments

An embodiment according to the present invention will hereinafter be described using the accompanying drawings.

### (First Embodiment)

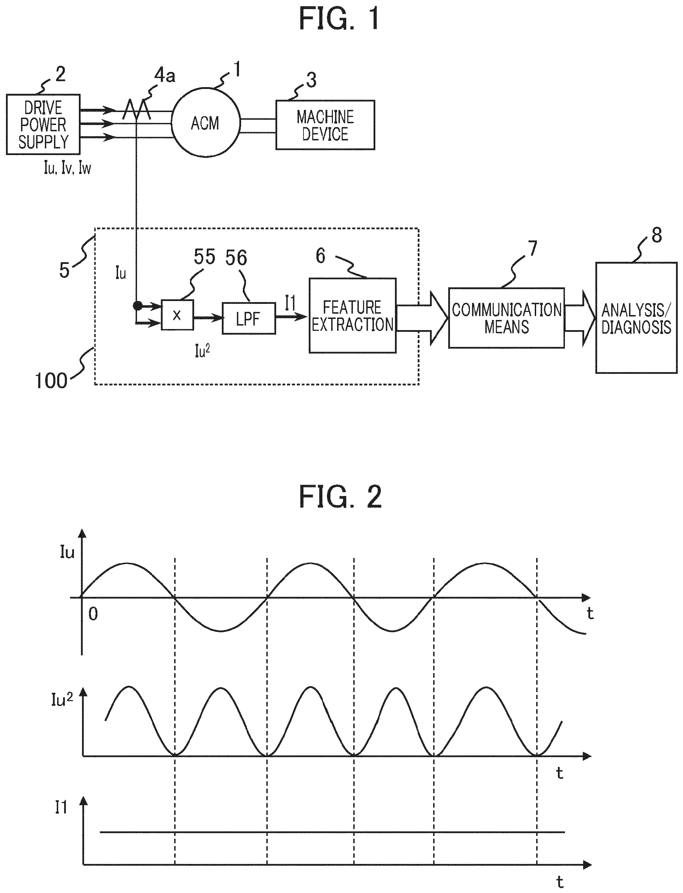

An electric motor drive system, an AC electric motor, and their monitoring device according to a first embodiment of the present invention will be described using Figs. 1 and 2.

The electric motor drive system shown in Fig 1 is intended to operate with a three-phase AC electric motor 1 (hereinafter simply abbreviated as an electric motor 1) as a power source, and is comprised of a drive power supply 2 of the electric motor 1, and a machine device 3 with the electric motor 1 as power. The drive power supply 2 is constituted by a power converter such as an inverter. The machine device 3 is directed to industrial equipment such as fans, pumps, compressors, machine tools, etc., and apparatuses each using an electric motor, such as automobiles, railway vehicles, household appliances, etc.

A monitoring apparatus 100 serves to monitor the operation of this system or the AC electric motor included in the system and detect aging and a malfunction, or the sign of an abnormal operation. In the present embodiment, it is assumed that the monitoring apparatus 100 is installed in the existing electric motor drive system as post installed one. A phase current of the electric motor 1 detected by a current sensor 4a is processed by a monitoring device 5 from which data is transmitted to an analysis/diagnosis device 8 via a communication means 7. The current sensor 4a serves as a current detecting means and detects the phase current of the electric motor 1. The phase current detected by the current detecting means is assumed to be a current detection value. The communication means 7 is constituted of a wired or wireless communication network. Further, it is also possible to temporarily store data in a flash memory even without always sending data to the analysis/diagnosis device via the communication means 7 and after a certain amount of data is accumulated, analyze it collectively. If the number of data is greatly reduced, and outside processing becomes unnecessary, analysis/diagnosis processing can also be executed inside the monitoring apparatus 100 without providing the analysis/diagnosis device 8.

The monitoring apparatus 100 of the present embodiment will next be described.

The phase current (which is a U-phase current but may be any phase in Fig. 1) detected by the current sensor 4a being the current detecting means is read into the monitoring device 5 provided in the monitoring apparatus 100, and converted to a DC amount. Incidentally, the monitoring device 5 is intended to be realized by a microcomputer or FPGA, and actually read via an A/D converter (the AD converter is omitted in Fig. 1).

Since an alternating current waveform changes momentarily sinusoidally, only simple sampling thereof makes it difficult to quickly detect the behavior of the electric motor (e.g., a load change or the impact of changes in machine device). For this reason, data cleansing is needed on top of shortening the sample period.

In the present invention, a multiplier 55 and a low-pass filter (LPF) 56 are used to convert an AC amount to a DC amount. The detected phase current Iu is squared by the multiplier 55, and then only a DC component I1 is extracted by the low-pass filter 56. Fig. 2 illustrates the waveforms of respective signals.

Using this I1, the behaviors of the electric motor drive system and the AC electric motor included in the electric motor drive system are monitored. A feature extractor 6 extracts the magnitude of I1, a pulsating component contained in I1, and a transient fluctuation component thereof and thereby outputs a feature amount. The feature amount indicates e.g., aging, and a value or change indicative of an abnormal operation. Further, the feature extractor 6 outputs, for example, at least one feature amount of the AC electric motor, the drive power supply, and the machine device. Then, the feature extractor 6 sends the feature amount to the analysis/diagnosis device 8 via the communication means 7. Incidentally, the details of the feature extractor 6 will be described in detail in sixth to tenth embodiments.

As described above, according to the present invention, it is possible to convert the alternating current of the electric motor drive system into the amplitude of the current and monitor the same.

### (Reference Example)

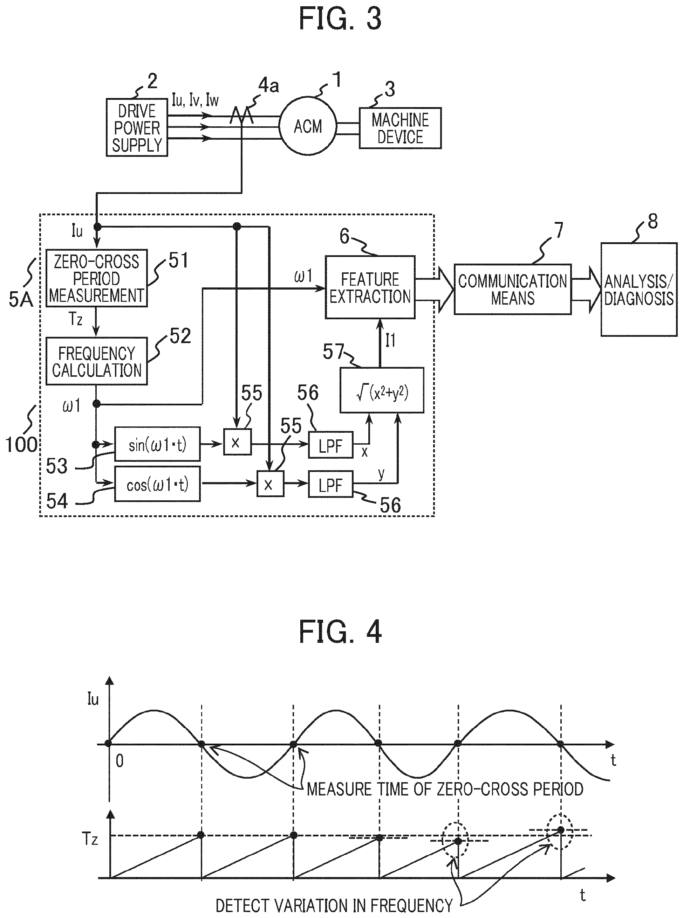

An electric motor drive system, an AC electric motor, and their monitoring device according to a reference example will be described using Figs. 3 and 4.

A block configuration diagram of the reference example is shown in Fig. 3. Fig. 3 shows a monitoring device 5A introduced instead of the monitoring device 5 in Fig. 1. Incidentally, in parts in Fig. 3, those identical in part numbers to those in Fig. 1 are identical to those in Fig. 1.

Using a zero-cross measuring instrument 51, the monitoring device 5A measures a half cycle of the phase current Iu being the current detection value and determines the AC frequency of the alternating current. As shown in Fig. 4, a zero-cross period of the phase current is measured by using a timer of the microcomputer, and its value is assumed to be Tz. Using this measured time Tz, a frequency calculator 52 calculates the AC frequency (angular frequency) ω1. Incidentally, since Tz is the half cycle of the AC waveform, it can be calculated as ω1 = π/Tz.

Using this ω1, an SIN wave generator 53 and a COS wave generator 54 calculate sin (ω1 t) and cos (ω1 t), and multipliers 55 are used to multiply them and the phase current waveform Iu with each other. Since an average value of the multiplication result of these becomes a value corresponding to a sin component and a cos component included in Iu, a sin component (x) and a cos component (y) can be extracted through low pass filters (LPF) 56.

Since x and y respectively coincide with the amplitudes of the sin component and cos component included in Iu, an AC absolute value calculator 57 calculates the magnitude (amplitude) I1 of the phase current Iu.

In this way, the magnitude I1 and the angular frequency ω1 of the alternating current Iu are obtained every half cycle of the alternating current. Current information can be converted at a higher speed than when the power spectrum described in Patent Literature is used.

Using these I1 and ω1, the behavior of the electric motor drive system is monitored. The feature extractor 6 extracts the pulsating component and transient fluctuation component contained in I1 and ω1 and thereby outputs a feature amount. Then, as with the first embodiment, the feature extractor 6 sends the feature amount to the analysis/diagnosis device 8 through the communication means 7.

As described above, according to the present invention, it is possible to convert the alternating current of the electric motor drive system into the amplitude and AC frequency of the current and monitor the same. Further, an observation period thereof can be shortened than when monitoring by the conventional power spectrum, and state monitoring including transient phenomena is made possible.

### (Second Embodiment)

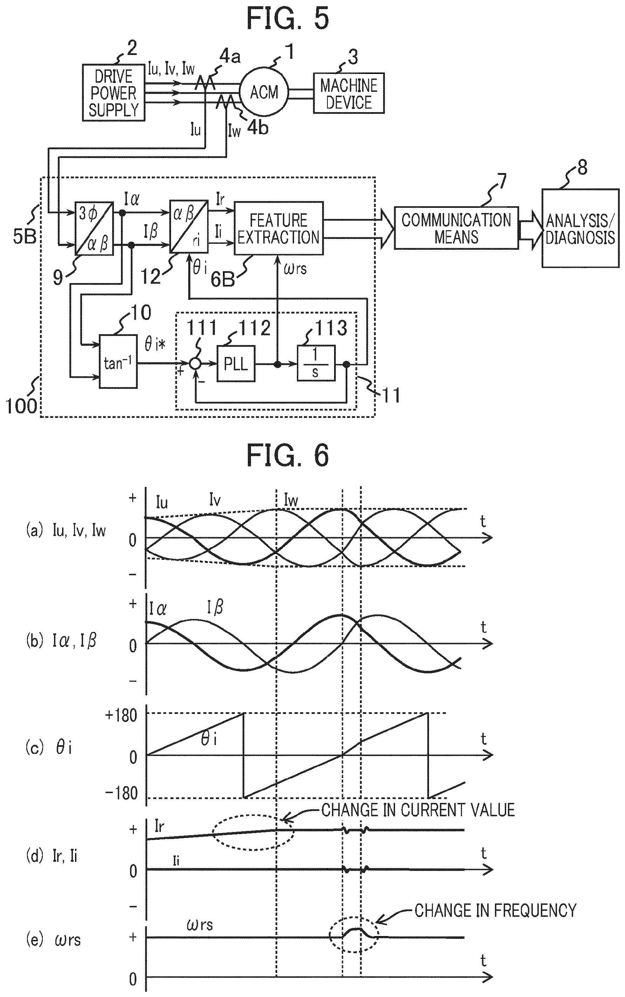

An electric motor drive system, an AC electric motor, and their monitoring device according to a second embodiment of the present invention will be described using Figs. 5 and 6.

A block configuration diagram of the second embodiment is shown in Fig. 5. Fig. 5 shows a case in which a W-phase current sensor 4b being a current detecting means is added to the configuration diagram of the reference example of Fig. 3, and further a monitoring device 5B is introduced instead of the monitoring device 5A. Incidentally, in parts in Fig. 5, those identical in part number to those in Fig. 3 are identical to those in Fig. 3.

In the reference example, the AC amount being the current detection value has been converted into the DC amount only by the current sensor of one phase. On the other hand, the monitoring device 5B detects two phases of motor currents of three phases and converts an alternating current being a current detection value into a DC amount. Consequently, it is possible to convert the alternating current to the DC current from instant to instant values without waiting for the calculation of the average value of a current waveform, and a zero cross signal. The detection of a shorter fluctuation component than the period of the alternating current is also possible.

In Fig. 5, the monitoring device 5B is comprised of a αβ converter 9 which converts a three-phase alternating current into alternating currents of orthogonal two phases, an arctangent calculator 10 which calculates, based on the two-phase alternating currents Iα and Iβ calculated by the αβ converter 9, its alternating current phase angle θi*, a phase calculator 11 which calculates a coordinate conversion phase θi relative to θi*, a rotating coordinate converter 12 which coordinate-converts Iα and Iβ into Ir and Ii being biaxial DC amounts on the basis of an output θi of the phase calculator 11, and a feature extractor 6B which inputs therein Ir and Ii converted into the DC amounts, and an angular frequency ωrs being an internal amount of the phase calculator 11 to calculate a feature amount used in state monitoring.

Incidentally, the phase calculator 11 is comprised of an adder 111 (where subtraction is performed) which calculates a deviation between the alternating current phase angle θi* and the coordinate conversion phase θi being the output of the phase calculator 11, a PLL controller 112 which performs PI control (proportional integral control) on the deviation and outputs the angular frequency ωrs, and an integrator 113 which integrates ωrs being the output of the PLL controller 112 to calculate the coordinate conversion phase θi.

Next, the operation of the monitoring device 5B will be described.

Based on Iu and Iw detected by the two-phase current sensors 4a and 4b, the αβ converter 9 converts them into two-phase alternating currents Iα and Iβ orthogonal to each other. The αβ conversion is calculated by the following (relative conversion): $Iα = \left(2/3\right) \left\{Iu-Iv/2-Iw/2\right\}$ $Iβ = \left(1/√\left(3\right)\right) \left\{Iv-Iw\right\}$ Incidentally, a V-phase current Iv is determined as Iv=-(Iu+Iw).

An αβ axis is the coordinates orthogonal to each other. The current phase θi* can be instantaneously calculated from values on the coordinates.$= {tan}^{- 1} \frac{{I}_{β}}{{I}_{α}}$

The resulting θi* is an instantaneous value of a current phase. The rotating coordinate conversion can also be performed using this value, but in the present embodiment, the coordinate conversion phase θi is calculated through the phase calculator 11. The reason for this is as described below.

Since a current ripple and noise are contained in the phase current, there is a possibility that when it is applied to the rotating coordinate conversion as it is, a large amount of ripples or noise are contained even in the converted DC amount. Therefore, the phase calculator 11 is introduced while also serving as the purpose of reducing noise and the purpose of calculating the frequency of the alternating current.

Further, the phase calculator 11 configures a control loop based on PLL control to thereby simultaneously perform the removal of noise and the frequency calculation of the alternating current. The PLL controller 112 outputs the angular frequency ωrs such that the coordinate conversion phase θi being the output of the integrator 113 and the current phase θi* coincide with each other. If θi and θi* coincide with each other, the output ωrs of the PLL controller 112 also coincides with the angular frequency of the alternating current, thus making it possible to obtain frequency information as well. Further, by setting the gain of the PLL controller 112, appropriate filtering is made, and the removal of noise is also possible.

In the PLL controller, the PI control (proportional integral control) is assumed to be performed, and the following calculation is performed.${ω}_{rs} = \left({K}_{pPLL}+{K}_{iPLL}\frac{1}{s}\right) \cdot \left({θ}_{i}^{∗}-{θ}_{i}\right)$

Incidentally, in the above equation, KpPLL means proportional gain, and KiPLL means integral gain. Incidentally, depending on the electric motor drive system, there are also applications performing rapid acceleration or deceleration of the electric motor 1 frequently. In that case, improvements such as adding the squared term of integration may be performed rather than simple PI control.

The rotating coordinate converter 12 converts Iα and Iβ into DC amounts on the basis of the coordinate conversion phase θi obtained in the phase calculator 11.$Ir = Iα ⋅ cos \left(θi\right) + Iβ ⋅ sin \left(θi\right)$ $Ii = - Iα ⋅ sin \left(θi\right) + Iβ ⋅ cos \left(θi\right)$

The above Ir and Ii can be calculated for each calculation processing cycle of the monitoring device 5B. It is possible to capture a sudden change in current or the like at that moment.

An operation waveform example of the present monitoring device is shown in Fig. 6. As illustrated in Fig. 6 (a), when the phase current waveform of the electric motor 1 gradually changes, it is difficult to detect this change while remaining at an AC amount. Especially when a sample of current is rough, processing after data acquisition takes a lot of time. Alternatively, it is extremely difficult to extract only the change amount from the AC waveform continuing to originally change, such as where there is a periodicity in the change of the amplitude.

In the monitoring device 5B, a three-phase AC is converted into two-phase alternating currents Iα and Iβ (Fig. 6(b)). The phase calculator 11 calculates a coordinate conversion phase θi (Fig. 6(c)). At θi, minute phase variations of the alternating current (frequency variation) can also be detected. It can be detected as a change in the angular frequency ωrs shown in Fig. 6(e). Further, a change in current amplitude can also be captured as a change in the DC value as shown in the Fig. 6(d). These changes are determined by the processing cycle of the monitoring device 5B, but if the recent digital processing is introduced, processing in a cycle of about several 10µs is made possible, and state monitoring including transient phenomena is possible.

These changes in the current value (amplitude value) after conversion to the DC amount and in frequency are captured as the feature amounts by the feature extractor 6B. After the amount of data has significantly been reduced, the data is transferred to the analysis/diagnosis device 8 through the communication means 7. By reducing the data, a communication load is greatly reduced.

The analysis/diagnosis device 8 saves these feature amounts as time-series data and diagnoses a temporal change in the electric motor drive system. Since the conversion to a previously easy-to-analyze state amount is made in the monitoring device 5B, it is also easy to apply a diagnostic algorithm.

As described above, according to the present invention, in terms of the monitoring of the alternating current of the electric motor drive system, it is possible to convert the instantaneous current detection value to the amplitude and frequency, and the state monitoring including the transient phenomena can be realized.

### (Third Embodiment)

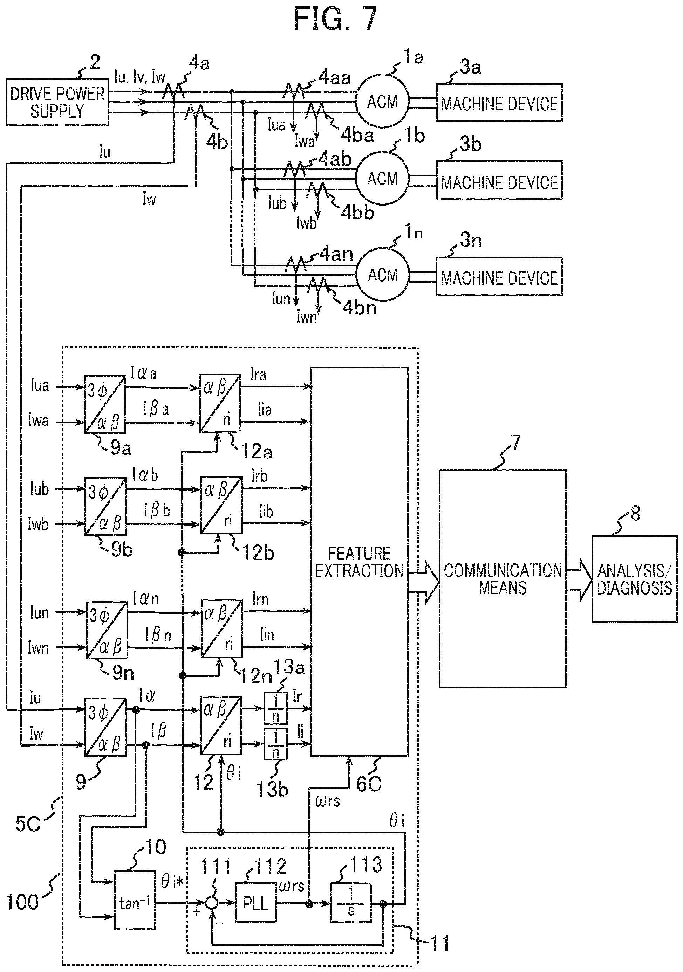

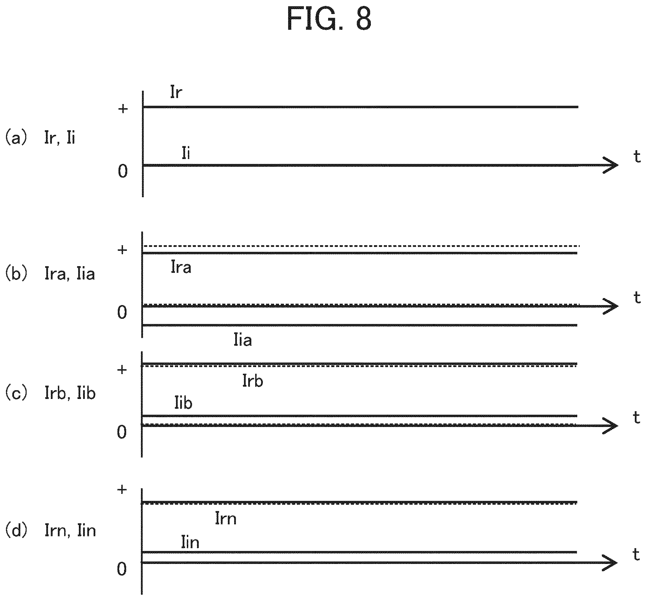

An electric motor drive system, an AC electric motor, and their monitoring device according to a third embodiment of the present invention will be described using Figs. 7 and 8.

Fig. 7 shows a block configuration diagram of the third embodiment.

In the present embodiment, the configuration of the electric motor drive system is characteristic. A plurality of (n) electric motors 1a to 1n and a plurality of machine devices 3a to 3n are connected in parallel to a single drive power supply 2. When an induction electric motor is used as an electric motor, such a configuration is possible. This is a configuration used in driving of transporting rollers of a rolling line in the steel industry, and a drive motor of a railway vehicle system, etc.

The drive power supply 2 supplies power with a plurality of electric motors being regarded as a single electric motor. However, when the machine devices are respectively different in load, the loads on the electric motors are also different. There is a possibility that troubles such as a case in which a load is concentrated on a specific electric motor or machine device to remarkably wear only the machine, etc. will occur.

In order to monitor to which electric motor and to which machine device a heavy burden is applied, or whether an abnormality such as vibration or the like occurs, there is a need to monitor each individual electric motor. However, since it is difficult to extract the feature amount as described above when the current is monitored while remaining at the AC amount, it is desirable to convert the AC amount into a DC amount once and monitor the same.

The present embodiment provides a state monitoring method of a system in which a plurality of electric motors are connected to a single drive power supply.

Fig. 7 shows that two current sensors corresponding to n numbers are added to n number of electric motors respectively, and a monitoring device 5C converts an alternating current of each electric motor into a DC amount and monitors the same. That is, a plurality of AC electric motors are driven by one drive power supply, and current sensors each being a current detecting means are provided in the respective AC electric motors. Incidentally, in parts shown in Fig. 7, those identical in part number to those shown in Fig. 3 or Fig. 5 are the same as those.

Next, the operation of the monitoring device 5C of the present embodiment will be described.

Output currents (currents corresponding to all electric motors) of the drive power supply 2 are detected by the current sensors 4a and 4b, and αβ conversion and a phase calculation are carried out based on their current values. This operation is exactly the same as the operation of the monitoring device 5B in the reference example. Incidentally, the current values of all the electric motors are set to be 1/n times at gains 13a and 13b to calculate Ir and Ii as an average value of the number of the electric motors.

U-phase and W-phase current sensors 4aa to n and 4ba to n are connected to the n electric motors. Their currents are αβ converted by αβ converters 9a to n and further converted into DC amounts Ira to Irn and Iia to Iin by rotating coordinate converters 12a to 12n respectively.

A coordinate conversion phase θi and an angular frequency ωrs are calculated from the value of the total current supplied from the drive power supply 2. The rotational coordinate conversion of the current of each electric motor is calculated in a common phase θi. That is, by outputting the feature amount on the basis of at least one of the amplitude, phase and frequency contained in the DC amount, the difference between the operating states of the individual electric motors can be clearly detected.

Fig. 8 shows operation waveforms of the present embodiment. Variation in current value of each motor can be captured as a DC amount with respect to Ir and Ii being an average current. For example, from the currents in Fig. 8 (b), it can be seen that the current Iia of the electric motor 1a is generated in negative form. From this point of view, only the electric motor 1a is seen to have been driven by a delayed phase current than the average value. Similarly, it can be seen that the electric motor 1b and the electric motor 1n assume a leading phase. It is understood from this waveform that there is a possibility that only the electric motor 1a is being driven under operating conditions different from others, and some sort of abnormality occur.

It is difficult to perform such analysis by only the detected value of the AC current waveform. However, the introduction of the monitoring device 5C makes it possible to facilitate feature extraction for detecting an abnormality and to considerably reduce the amount of data required for monitoring as well.

Incidentally, the embodiment has shown the example of placing two by two the current sensors in the electric motors, but the method using one current sensor such as shown in the first embodiment is also applicable if only monitoring of steady operation is taken. Further, the current sensors 4a and 4b detecting the total current of the drive power supply 2, are removed, and instead the values obtained from the current sensors of the individual electric motors are added together to also enable its result to be taken as information of the total current.

### (Fourth Embodiment)

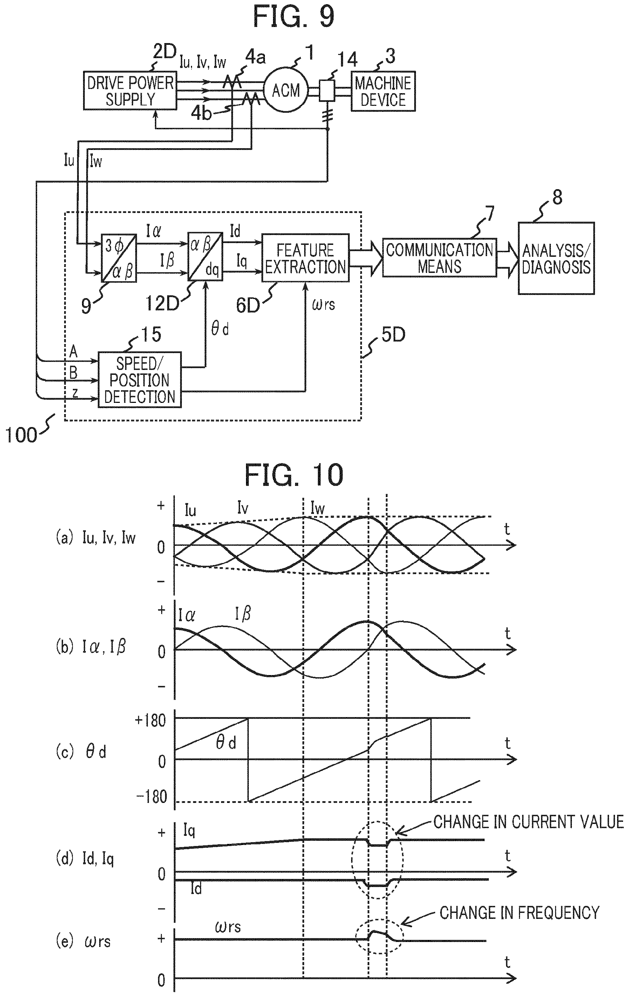

An electric motor drive system, an AC electric motor, and their monitoring device according to a fourth embodiment of the present invention will be described using Fig. 9 and Fig. 10.

Fig. 9 shows a block configuration diagram of the fourth embodiment.

Fig. 9 shows a feature that in the configuration diagram of the second embodiment shown in Fig. 5, a rotation shaft sensor 14 is mounted to the rotating shaft of the electric motor 1. Based on a signal detected by the rotation shaft sensor, electric motor control is performed by a drive power supply 2D. Further, as a monitoring device, a monitoring device 5D is introduced instead of the monitoring device 5B of Fig. 5. Incidentally, in parts in Fig. 9, those identical in part number to those in Figs. 3 to 7 are the same as those. In the present embodiment, the rotation shaft sensor is used as a rotation shaft measuring means, but is not limited thereto.

In the embodiments described thus far, the current sensor is added to the existing electric motor drive system to monitor the electric motor drive system using only its current detection value. However, the rotation shaft sensor of the electric motor 1 is connected as shown in Figure 9, depending on the system. Further, depending on conditions, it may be possible to retrieve the signal of the rotation shaft sensor. The configuration of the present embodiment resides in that targeting such an electric motor drive system, the detected current is converted into a DC amount by utilizing the existing rotation shaft sensor.

In Fig. 9, the rotation shaft sensor 14 is connected to the rotating shaft of the electric motor 1, and is a pulse encoder which outputs pulse signals of A, B and z phases in accordance with the rotation of the electric motor 1. The pulse encoder is a speed sensor generally used in an AC servo system or the like. It is possible to generate a position (angle) signal by integrating an output pulse train. To perform a home position alignment of a mechanical angle, a z phase to generate one pulse in one rotation is also assumed to be output.

A feature part of the present embodiment is that the pulse signals are diverted in the monitoring device 5D to utilize the same for the coordinate transformation of the detected AC current.

In the monitoring device 5D, a speed/position detector 15 counts the numbers of pulses of the A and B phases to thereby calculate the rotational speed of the electric motor 1 and further integrates the pulse train to thereby calculate a phase θd of the rotation shaft. Since this θd is linked with the alternating current phase of the electric motor 1, the current on the αβ-axis can be converted into a DC amount if rotating coordinate conversion is performed based on θd. Further, if resetting of the phase angle is done based on the z-phase signal, the coordinates of the dq-axis of the electric motor 1 are obtained, whereby phase information of the inside of the drive power supply 2D can be obtained.

In a rotating coordinate converter 12D, a calculation is performed in the same manner as (Numeral 5) and (Numeral 6) based on the phase θd to convert the current into a DC amount. As a result of this conversion, a d-axis current and a q-axis current used for vector control of the AC electric motor can be calculated. Since the generated torque of the electric motor 1 is proportional to the q-axis current, it is possible to monitor the generated torque of the electric motor 1 by monitoring Iq.

Further, unlike the embodiment of Fig. 5, since it is not necessary to perform the phase calculation from Iα and Iβ, the influence of a delay due to the PLL controller can be eliminated, and more accurate state monitoring is made possible.

Fig. 10 shows observed waveforms when the present embodiment is used. Changes in the current and a change in the rotational speed can be observed as with the waveform example of Fig. 4. However, in the first to third embodiments, the current is converted into the DC amount on the basis of the phase of the current itself, whereas in the present embodiment, the conversion based on the information of the rotation shaft sensor is performed, and hence more precise movement of current can be captured. Further, since ωrs is a signal obtained from the actual rotation shaft sensor, the rotational speed itself is eventually detected. It is thus possible to realize more accurate monitoring.

Incidentally, even when one other than the pulse encoder, for example, a sensor such as a resolver, a Hall element or the like is used as the rotation shaft sensor, it is possible to achieve above realization similarly.

### (Fifth Embodiment)

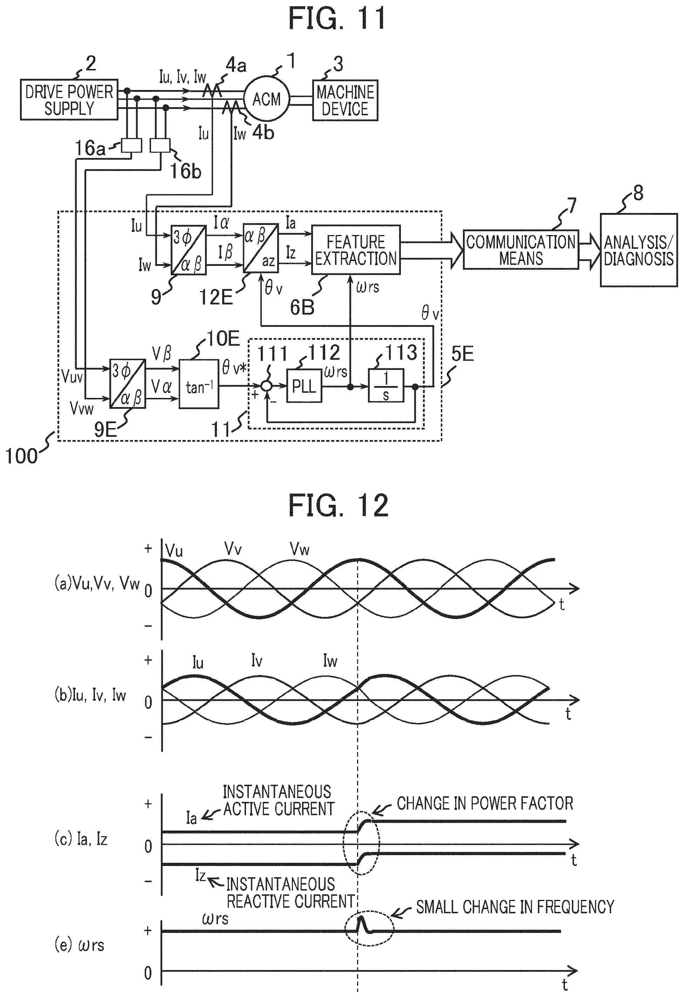

An electric motor drive system, an AC electric motor, and their monitoring device according to a fifth embodiment of the present invention will be described using Fig. 11 and Fig. 12.

Fig. 11 shows a block configuration diagram of the fifth embodiment.

Fig. 11 shows a feature that voltage sensors 16a and 16b each detecting an inter-line voltage of an electric motor 1 are attached to the configuration diagram of the second embodiment shown in Fig. 5. The voltage sensors serve to detect inter-line voltages Vuv and Vvw and thereby to help monitoring of the electric motor drive system. Further, as the monitoring device, a monitoring device 5E is introduced instead of the monitoring device 5B of Fig. 5. Incidentally, in parts in Fig. 11, those identical in part number to those in Figs. 1 to 9 are the same as those. In the present embodiment, the voltage sensor is used as a voltage detecting means, but is not limited thereto.

The monitoring device 5E in Fig. 11 inputs the inter-line voltage Vuv, and Vvw therein, and converts the three-phase voltage into biphasic Vα and Vβ at an αβ converter 9E. The conversion from the inter-line voltage to the phase voltage can be calculated as follows: $Vu = \left(2/3\right) \left\{Vuv+Vvw/2\right\}$ $Vw = - \left(2/3\right) \left\{Vvw+Vuv/2\right\}$ $Vv = - \left(Vu+Vw\right)$ Further, Vα and Vβ are calculated in the above-described (Numeral 1) and (Numeral 2). An arctangent calculator 10E calculates a voltage phase θv* on the basis of the equation (Vα is used instead of Iα, and Vβ is used instead of Iβ) shown in the (Numeral 3). A phase calculator 11 is operated to control a coordinate conversion phase θv, so as to follow a voltage phase θv*. A rotating coordinate converter 12E converts Iα and Iβ into DC amounts according to the phase of θv.

Since θv is the phase of the output voltage of the drive power supply 2, the current observed on this coordinates is calculated as an active current in phase with an AC voltage and a reactive current orthogonal to the AC voltage. These coordinate transformation is calculated in accordance with a (Numeral 10) and a (Numeral 11) at the rotating coordinate converter 12E, so that an active current component Ia and a reactive current component Iz can be determined.$Ia = Iα ⋅ cos \left(θv\right) + Iβ ⋅ sin \left(θv\right)$ $Iz = - Iα ⋅ sin \left(θv\right) + Iβ ⋅ cos \left(θv\right)$

It can be seen that if the active current Ia is monitored, the load torque or power consumption is changed. Thus, the state monitoring of the electric motor 1 and the machine device 3 can be carried out more accurately.

Fig. 12 shows an example of current and voltage waveforms of the electric motor 1, and waveforms of an active current Ia and a reactive current Iz obtained by the monitoring device 5E. The phase of the AC current waveform changes in the middle of the Figure, but the absolute value itself of the current has no change. Also, the frequency does not change either except during transition. In the present embodiment, the monitoring device 5E is capable of capturing that the current phase clearly changes by observing the current as the active current and the reactive current, and an increase in the active current, i.e., power consumption is also increased.

### (Sixth Embodiment)

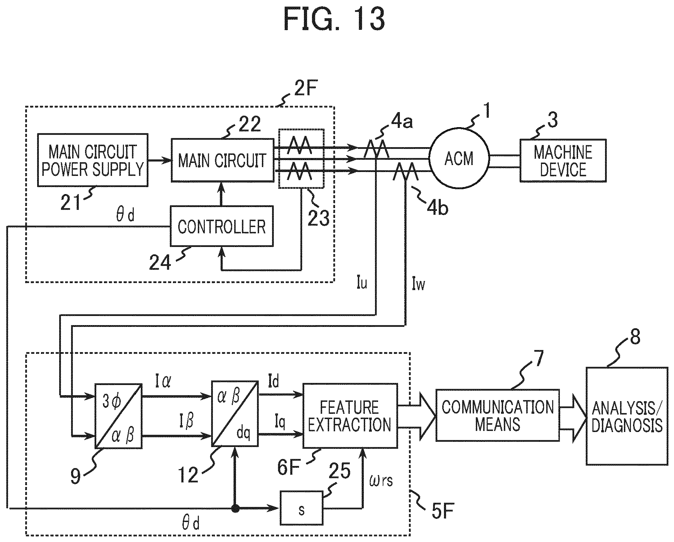

An electric motor drive system, an AC electric motor, and their monitoring device according to a sixth embodiment of the present invention will be described using Fig. 13.

Fig. 13 shows that in the configuration diagram of the fourth embodiment shown in Fig. 9, without using the rotation shaft sensor of the electric motor 1, phase information □d used inside a drive power supply 2F is drawn to the outside instead, and a monitoring device 5F converts an alternating current into a direct current on the basis of the phase information □d to perform state monitoring of the electric motor drive system.

First of all, description will be made in detail as to an internal configuration of the drive power supply 2F of the embodiment shown in Fig. 13. The drive power supply 2F is an inverter for controlling the electric motor 1 and is comprised there inside of a main circuit power supplier 21 which supplies power to an inverter main circuit unit, a main circuit 22 of the inverter which applies an arbitrary AC voltage to the electric motor 1, a current sensor 23 which detects an AC output current of the main circuit 22, and a controller 24 which controls the inverter main circuit unit 22 based on a current detection value obtained by the current sensor 23. The controller 24 calculates the phase information □d being an internal phase for vector control of the electric motor 1. In Fig. 13, the rotation shaft sensor of the electric motor 1 is not attached, and the estimation calculation of a rotation shaft position (angle) is performed inside the controller 24 to calculate □d.

The monitoring device 5F receives the phase information □d being an internal value of the drive power supply 2F and coordinate-converts the alternating current in the same manner as Fig. 9, based on the phase information to calculate currents of a d-axis and a q-axis. Incidentally, the transfer of □d between the drive power supply 2F and the monitoring device 5F is carried out via a serial communication, an analog signal, etc. Further, in order to calculate the frequency ωrs of the alternating current, a PLL controller may be newly introduced, or a differential operation unit 25 may be introduced as shown in Fig. 13 to calculate the angular frequency by differential operation.

As described above, according to the present embodiment, the state monitoring similar to that in the fourth embodiment (Fig. 9) can be realized without using the rotation shaft sensor.

### (Seventh Embodiment)

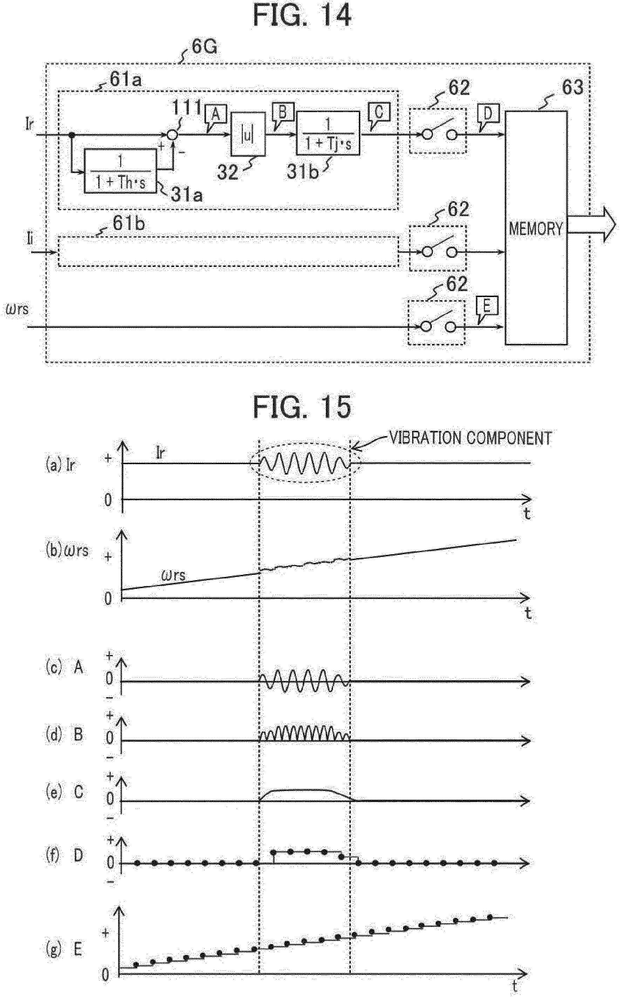

A monitoring device according to a seventh embodiment of the present invention will be described using Figs. 14 and 15.

Fig. 14 shows a block configuration diagram of a feature extractor 6G usable in the monitoring devices 5 and 5B to 5F described so far. The seventh embodiment can be realized by using the feature extractor 6G for the feature extractor according to each of other embodiments.

The feature extractor 6G of the present embodiment provides a function of extracting a vibration component from alternating currents Ir and Ii each converted into a DC amount, or from an angular frequency ωrs.

The feature extractor 6G of Fig. 14 is comprised of vibration component extractors 61a and 61b which extract vibration components included in the currents Ir and Ii each converted to the direct current, sample switches 62 each of which samples data, and a memory 63 which stores the data. The vibration component extractor 61a is comprised of a first-order lag filter 31a of a time constant Th, an adder 111, an absolute value calculator 32, and a first-order lag filter 31b of a time constant Tj.

The operation of the vibration component extractor 61a shown in Fig. 14 will be described using a waveform example of Fig. 15.

As an example of the waveform, the current Ir which has been converted into the DC amount, is assumed to include vibration such as shown in Fig. 14(a). Such vibration often occurs where, for example, a drive frequency of an electric motor 1 and a mechanical resonance frequency of a machine device 3 match each other. Therefore, there occur such phenomena that when the electric motor 1 is accelerating, vibration is generated when the drive frequency is approaching the mechanical resonance frequency, and vibration is suppressed again when exceeding the region of its rotational speed. If these vibration phenomena and an AC frequency at which they occur are associated with each other, an abnormality of the machine device and its changes with time can be detected, thereby making it possible to help state monitoring.

In the vibration component extractor 61a, in order to extract only a vibration component included in the current Ir, a current value through the first-order lag filter of the time constant Th (as this current value, the average value at which the vibration component is canceled is output) is subtracted from the original Ir (the adder 111 being used as a subtractor in Fig. 14) to thereby extract only the vibration component (a waveform of 'A' shown in Fig. 15(c)). Further, the absolute value of the signal 'A' is determined by the absolute value calculator 32 to obtain a waveform of 'B' shown in Fig. 15(d). Since 'B' is a waveform like a full-wave rectification, it further passes through the first-order lag filter 31b of the time constant tj to output only a DC component (a waveform 'C' in Fig. 15(e)). That is, when vibration occurs in the direct current Ir, the vibration component is output as the value of the DC amount from the vibration component extractor 61a. In the sample switch 62, the waveform is sampled at predetermined intervals and stored in the memory 63. It is possible to extract a vibration component by performing the same processing even on the DC amount Ii. In any case, as compared to analyzing the alternating current waveform while remaining in the AC amount, the conversion of the AC amount into the DC amount enables a vibration component to be extracted by a simple algorithm.

Further, if the angular frequency ωrs of the alternating current is sampled simultaneously by the sample switch 62 and stored in the memory 63, the correlation between the drive frequency and the vibration component can be stored as data. By analyzing the correlation, it can be utilized as a feature amount for determining a variation in a resonance point of the machine device, i.e., the wear and deterioration of the device.

Incidentally, in the present embodiment, there has been shown the example of extracting the vibration component included in the current, but the extraction of the vibration component of the angular frequency ωrs is also possible. Further, in the case of the second embodiment (Fig. 7), the extraction of a vibration component for each electric motor is also possible with respect to each individual electric motor.

As described above, by using the feature extractor according to the present embodiment, it is possible to extract the vibration component in the simple algorithm, and it is possible to help state monitoring of the electric motor drive system.

### (Eighth Embodiment)

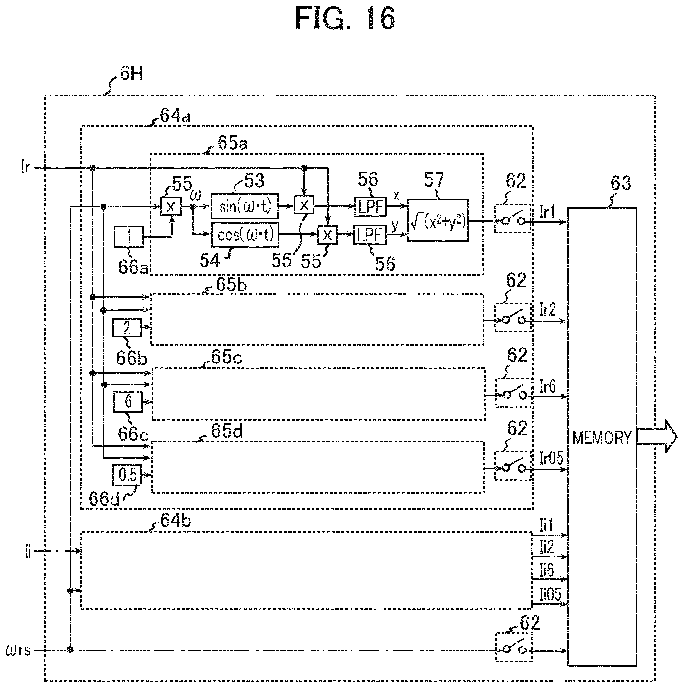

A monitoring device according to an eighth embodiment of the present invention will be described using Fig. 16.

Fig. 16 shows a block configuration diagram of a feature extractor 6H usable in the monitoring devices 5 and 5B to 5F described so far. The eighth embodiment can be realized by using the feature extractor 6H for the feature extractor according to each of other embodiments.

The feature extractor 6H of the present embodiment provides a function of specifying and extracting alternating currents Ir and Ii each converted into a DC amount, or pulsating components contained in an angular frequency detection value, up to the frequency.

When an electric motor is driven with an inverter as a drive power supply, there often occurs in the pulsating component of the current with a drive frequency as a primary component, vibration of the order of its integral multiple or the order of 1/integer times the frequency. Further, there is a possibility that the cause of the vibration can be specified depending on whether the vibration is generated in the vicinity of the drive frequency of any electric motor. Therefore, the execution of a frequency analysis with the drive frequency as the reference in real time is very important for the state monitoring.

In Fig. 16, the feature extractor 6H is comprised of pulsating component analyzers 64a and 64b which perform component analysis corresponding to the order of the frequency with respect to Ir and Ii each converted into the DC amount, and a memory 63 which stores a result of its analysis. Further, the pulsating component analyzers 64a and 64b are respectively comprised of frequency analyzers 65a to 65d, constant setters 66a to 65d, and sample switches 62.

As operations of the frequency analyzers 65a to 65d, those quite equal to the calculation algorithm for the current amplitude I1 in the first embodiment are used. However, the angular frequency ω input to the SIN wave generator 53 and the COS generator 54 is given by multiplying ωrs by constants (1, 2, 6, 0.5) set by the constant setters 66a to 66d respectively.

In the constant setter 66a, since '1' is set as a constant, ω = ωrs. As a result, the frequency analyzer 65a performs extraction of the pulsating component of ωrs (i.e. the primary component of ωrs). Its calculation result Ir1 is sampled by the sample switch 62 and stored in the memory 63.

Similarly, the frequency analyzer 65b, the frequency analyzer 65c, and the frequency analyzer 65d can extract a secondary component of □ωrs, a 6-order component thereof, and a 1/2-order component thereof respectively.

In the present embodiment, the primary, secondary, sixth-order, and 0.5-order pulsating components can be extracted with respect to the drive frequency. These pulsation factors can be considered as follows.

The primary component of the drive frequency is apt to occur when the offset current (DC component) of the drive power supply (inverter) occurs, and the abnormality of the drive power supply is estimated. Further, the secondary component is likely to occur when a three-phase imbalance has occurred. It occurs even such as where the electric motor is demagnetized by heating. As for the sixth-order pulsation, spatial harmonics of the electric motor, cogging torque, or strain of the inverter, or the like may be a factor. Further, when the number of poles of the electric motor is four, a load fluctuation for each revolution occurs as a 1/2-order pulsating component. Alternatively, even when the rotation shaft is made eccentric, the first-order component of a rotation frequency (1/2-order pulsating component of an electrical angular frequency if a four-pole machine is taken) is generated. Thus, depending on which pulsations of orders occur, it is possible to infer the cause thereof. Further, if such specific frequencies are extracted in the monitoring device, the work of subsequent analysis/diagnosis is easy, and hence it can help state monitoring.
Incidentally, in the present embodiment, there has been shown the example of extracting the primary, secondary, 6-order, and 0.5-order pulsating components with respect to the drive frequency, arbitrary orders can be set for these.

### (Ninth Embodiment)

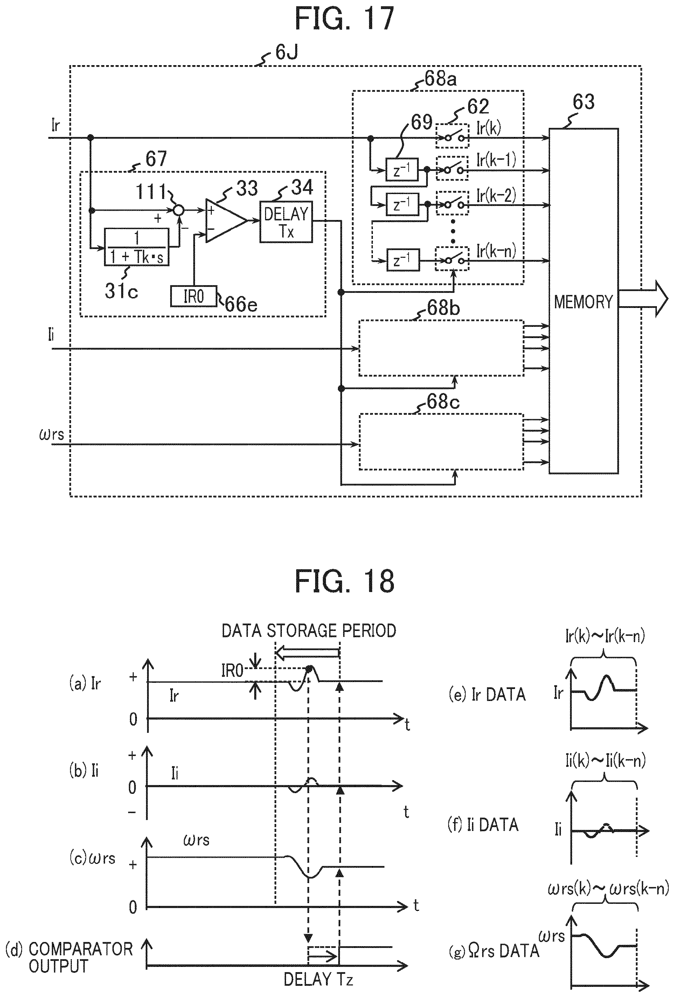

A monitoring device according to a ninth embodiment of the present invention will be described using Figs. 17 and 18.

Fig. 17 shows a block configuration diagram of a feature extractor 6J usable in the monitoring devices 5 and 5B to 5F described so far. By using the feature extractor 6J for the feature extractor according to each of other embodiments, it is possible to realize the ninth embodiment.

The feature extractor 6J of the present embodiment captures transient phenomena when alternating currents Ir and Ii each converted into a DC amount vary beyond a preset threshold value (predetermined range), and stores time-series data before and after it.

In the ninth embodiment, the transient phenomenon of the current Ir or Ii converted to the DC amount is captured, and a varying waveform before and after it is saved, thereby helping state monitoring.

The feature extractor 6J shown in Fig. 17 is comprised of a trigger signal generator 67 which observes an amount of change in the current Ir converted into the DC amount and generates a trigger signal where it exceeds IR0 being a change amount set in advance, i.e., where it exceeds a predetermined range, sample value, sample value storing units 68a to 68c each of which stores values up to the previous n samples with respect to the currents Ir and Ii and angular frequency ωrs, and a memory 63.

In the trigger signal generator 67, the amount of change in the current Ir is calculated by a first-order lag filter 31c and an adder 111 (operated as a subtractor in this case), and the amount of its change is compared with IR0 being a preset reference value in a comparator 33. IR0 is set at a constant setter 66e. When a fluctuation occurs in Ir and Ir exceeds IR0, the output of the comparator 33 becomes '1'. As the comparator output, the trigger signal is output via a delay circuit 34 with a delay of a delay time Tx.

The sample value storage units 68a to 68c sequentially store the past sample values by one sample delay elements 69 (1/z), and store internal values up to past n samples. With the input of the trigger signal to the sample value storage unit, sample switches 62 simultaneously perform sampling, and n pieces of data are stored into the memory 63. A behavior waveform with the fluctuation in Ir as a trigger is stored in the memory 63.

Fig. 18 shows the operation waveforms of the present embodiment. The waveforms show an example when the current waveform of Ir changes rapidly due to a load fluctuation or the like. When the current waveform exceeds the preset value IR0, the output of the comparator 33 becomes '1'. However, via a delay time Tz therefrom, a trigger is given to the sample value storage units 68a to 68c. As a result, it is possible to store the transient phenomena at such timings as shown in Figs. 18(a), (b), and (c).

N pieces of data of Ir, Ii, and ωrs being the past data at the transition are stored in the memory 63 as shown in Fig. 18(e), (f), and (g). The transient phenomenon of the electric motor is an important factor relating to the control response. For example, when the electric motor constant is changed by temperature or the like, there is a high possibility that it can be observed as a difference in transient phenomenon. Thus, the relationship of transition between these currents and the drive frequency is stored as data and can be made useful in the analysis. The amount of variation to be used for analysis includes the amount of variation in the DC amount, or the amount of change in frequency used in converting the current detection value to the DC amount.

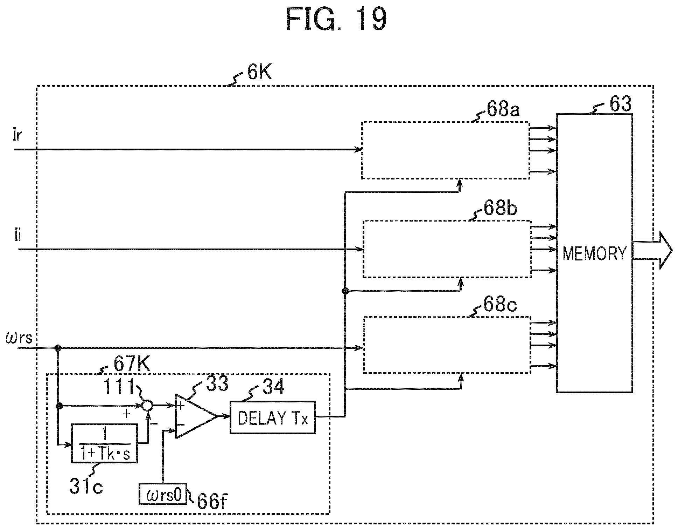

Similarly, there is shown in Fig. 19, the configuration of storing changes in the currents Ir and Ii with the time when the angular frequency ωrs fluctuates beyond the threshold value (predetermined range) as a trigger. A feature extractor 6K and a trigger generator 67K are substantially the same as the embodiment of Fig. 17, but different in that the factor of trigger occurrence is ωrs. Further, as a reference value of a speed variation, an angular frequency ωrs0 is set by a constant setter 66f. Similarly to Fig. 18 even in the present embodiment, with the angular frequency ωrs as the trigger, the waveform before and after the trigger occurs can be observed. The amount of variation used for the analysis in this case includes the amount of change in the frequency, or the amount of change in the DC amount.

As described above, according to the present embodiment, it is possible to capture the changes in the current and angular frequency caused by the transient phenomena of the electric motor and machine device and store their waveforms, thereby making it possible to help state monitoring and maintenance.

### (Tenth Embodiment)

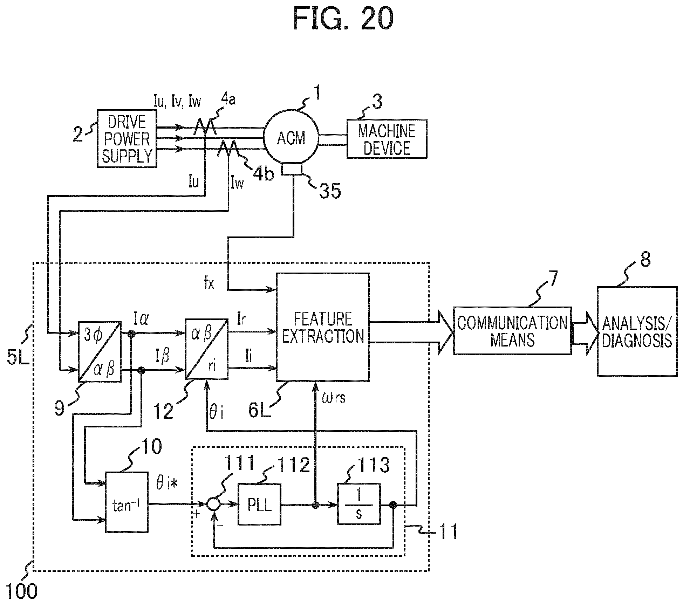

An electric motor drive system, an AC electric motor, and their monitoring device according to a tenth embodiment of the present invention will be described using Figs. 20 to 22.

Fig. 20 shows a block configuration diagram of the tenth embodiment.

Fig. 20 shows a feature that in the configuration diagram of the second embodiment shown in Fig. 5, a vibration sensor 35 is attached to an electric motor 1. A vibration acceleration fx detected by this vibration sensor is read into a monitoring device 5L, and a feature amount is extracted by a feature extractor 6L. Other parts are the same as those of Fig. 5 in the second embodiment.

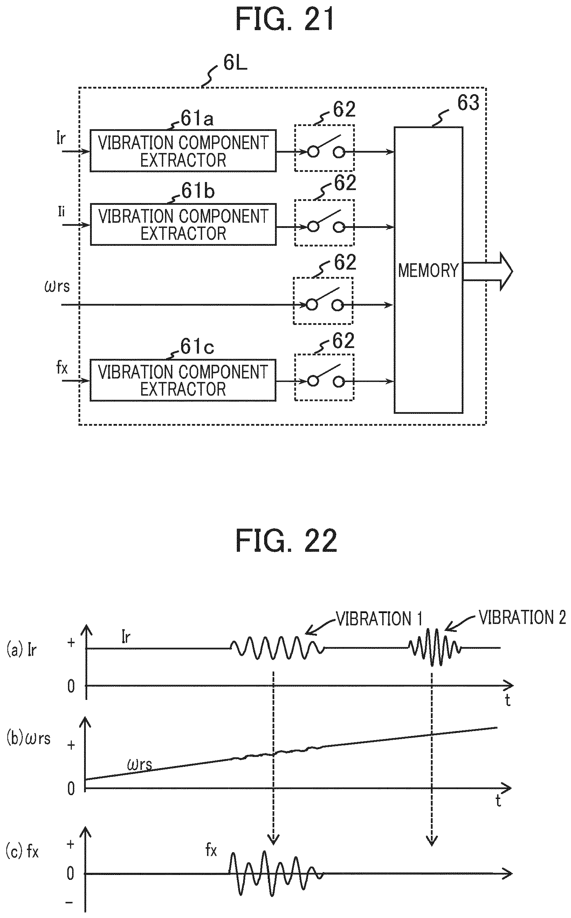

Fig. 21 shows the configuration of the feature extractor 6L. The feature extractor 6L show substantially the same configuration as that of the feature extractor 6G of the sixth embodiment shown in Fig. 14. A vibration component extractor 61c which receives the vibration acceleration fx, and a sample switch 62 for its output are added. With this configuration, it is also possible to extract a vibration component contained in fx in addition to the vibrations of currents Ir and Ii.

By extracting the vibration component of fx simultaneously with the vibration components of Ir and Ii, a new effect is obtained, and its description will therefore be made. Fig. 22 shows the waveforms of the Ir, angular frequency ωrs, and vibration acceleration fx. When the drive frequency and the mechanical resonance frequency coincide with each other during acceleration, the large vibration has occurred. This has already been described using Fig. 15. In the case of the vibration due to such mechanical resonance, it is confirmed that large vibration is observed even at the output fx of the vibration sensor, and is a mechanical resonance phenomenon. Further, there is a case where when acceleration is made to a high speed, for example, a vibration phenomenon like 'vibration 2' in Fig. 22 occurs. In this case, no vibration is generated in the vibration sensor. From this point of view, it can be seen that the vibration phenomenon irrelevant to the mechanical resonance has occurred in Ir. In other words, vibration occurring in a control loop of an electric system irrelevant to a mechanical system can be read from these waveforms.

Thus, the correlation between the information of the external sensor and the DC amount is analyzed, and the feature amount is extracted, thereby making it possible to separate vibration factors and help state monitoring.

Incidentally, the vibration sensor may be attached to the machine device, for example. Alternatively, a three-dimensional acceleration sensor may be used. Further, as the external sensor, instead of the vibration sensor, a noise sensor (microphone), a temperature sensor, or a humidity sensor may be used.

Further, in the sense to perform association with the driving state of the electric motor, it is also considered that other sensor information are read and combined even in addition to the vibration sensor. For example, in the case of a compressor such as an air conditioner, if pressure sensor information of the machine device is used or information of the temperature sensor, the humidity sensor, etc. are captured simultaneously, the correlation with the driving state of the electric motor 1 can be saved as data, thereby making it possible to help state monitoring.

### (Eleventh Embodiment)

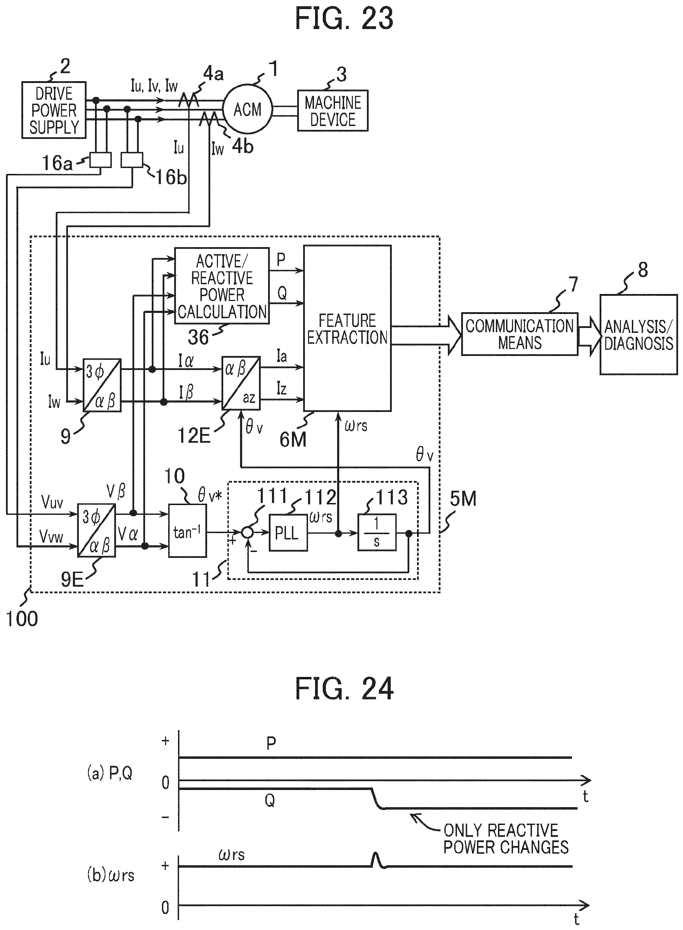

An electric motor drive system, an AC electric motor, and their monitoring device according to an eleventh embodiment of the present invention will be described using Figs. 23 and 24.

Fig. 23 shows a block configuration diagram of the eleventh embodiment.

Fig. 23 illustrates a configuration in which in the configuration of the fifth embodiment shown in Fig. 11, a monitoring device 5M is introduced instead of the monitoring device 5E. The monitoring device 5M has a configuration in which an active/reactive power calculator 36 is newly added, and calculates active power P and reactive power Q and inputs their calculated values to a feature extractor 6M.

In the fifth embodiment, the voltage information of the drive power supply 2 is utilized based on the inter-line voltage information, and the alternating current of the electric motor is monitored by being separated into the active current component and the reactive current component. In the present embodiment, it is further monitored by being converted into the active power P and the reactive power Q.

The active/reactive power calculator 36 performs the following operations using the current and voltage on a αβ-axis. $P = \left(3/2\right) \left\{Vα⋅Iα+Vβ⋅Iβ\right\}$ $Q = \left(3/2\right) \left\{Vα⋅Iβ-Vβ⋅Iα\right\}$ Using at least one of the active power P and the reactive power Q calculated from the above equations, the feature extractor 6M extracts and outputs a feature amount such as aging, an abnormal operation or the like. Then, the monitoring of states of the electric motor drive system and the AC electric motor is performed.

Sine the active power P means that the power consumption of the system is calculated instantly, it is possible to monitor the amount of power consumption of the system. Further, since it is possible to monitor how the amount of power consumption changes by stacking the number of years, it can help maintenance of the machine device.

Fig. 24 shows an example of monitored waveforms of the active power P and the reactive power Q. In the figure, figure, only the reactive power suddenly changes in the middle, and the angular frequency ωrs and active power P are not changed. It can be seen that when such a phenomenon is assumed to have occurred, the power consumption required for the machine device 3 remains unchanged, and only the reactive power increases (increases in the negative direction). As its factors, for example, it is expected that the original power supply voltage of the drive power supply 2 is lowered, the magnitude of the voltage applicable to the electric motor 1 is reduced, so that the electric motor 1 is performing a weakening field operation. That is, it becomes possible to determine even abnormality of the drive power supply 2.

By monitoring the values of the active power and the reactive power in this manner, it becomes possible to monitor the operating state of the electric motor drive system in more detail.

### (Twelfth Embodiment)

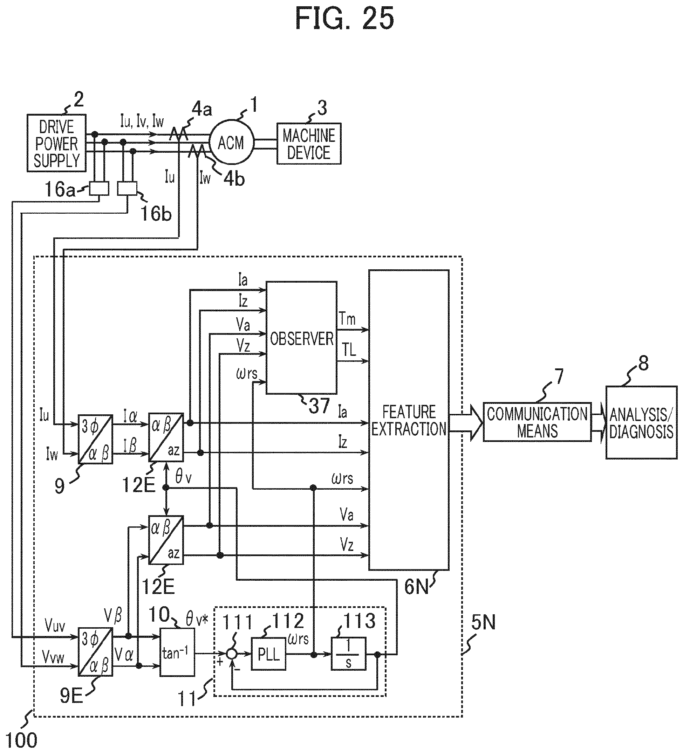

An electric motor drive system, an AC electric motor, and their monitoring device according to a twelfth embodiment of the present invention will be described using Figs. 25 to 27.

Fig. 25 shows a block configuration diagram of the twelfth embodiment.

Fig. 25 shows a configuration in which in the configuration of the fifth embodiment shown in Fig. 11, a monitoring device 5N is introduced instead of the monitoring device 5E. The monitoring device 5N is added with a rotating coordinate converter 12E which coordinate-converts Vα and Vβ at a phase angle θv, and a state observer 37 at which voltages Va and Vz on the rotating coordinates are computed and which further observes an internal state amount of the electric motor 1. The state observer 37 observes a state amount of the system which is not detected directly, by estimating and calculating the same, thereby helping monitoring. In the present embodiment, the estimation calculation of generated torque Tm of the electric motor 1 and load torque TL thereof each being the state amount of the system is performed on the basis of a mathematical model of the electric motor 1 and a mathematical model of the machine device 2. A feature extractor 6N inputs therein Ia, Iz, Va, Vz, ωrs, etc. in addition to the output of the state observer 37 and performs state monitoring at the time of steady-state and transition.

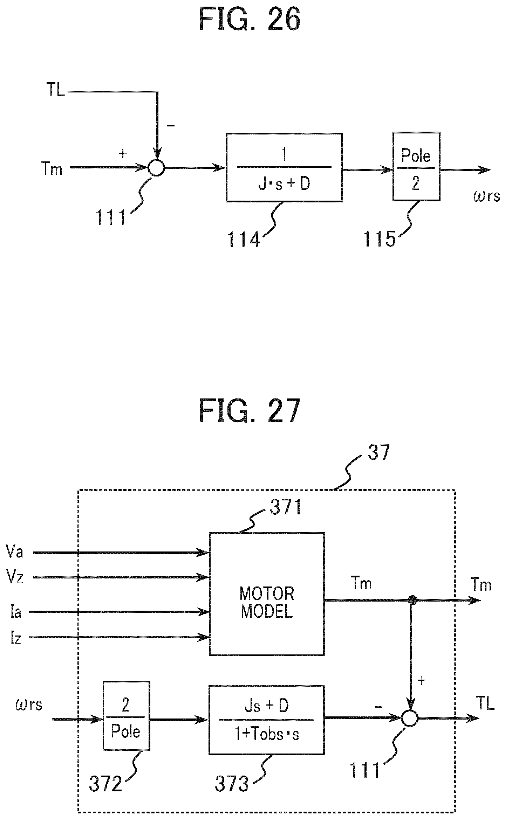

Fig. 26 shows a physical model representing the relationship between the motor torque Tm, the load torque TL, and the angular frequency ωrs in a block diagram. As shown in the figure, it can be seen that the rotational speed of a mechanical angle is obtained by the difference between the torque Tm generated by the electric motor 1 and the load torque TL generated by the machine device 3, inertia J of a mechanical system including an electric motor, and a damping coefficient D. Further, by multiplying it by the number of pole pairs Pole/2 of the electric motor 1, the electrical angular frequency ωrs of the electric motor 1 can be obtained. With these block diagrams as the principle, the state observer 37 calculates back the load torque TL.

Fig. 27 shows a block configuration of the state observer 37. In the figure, with the voltages Va and Vz and the currents Ia and Iz after the rotating coordinate conversion being taken as inputs, a motor model 371 being a mathematical model of the electric motor 1 determines the generated torque Tm of the electric motor 1 by calculation. Further, an inverse model of the physical model to obtain the angular frequency ωrs shown in Fig. 26 is implemented by a gain 372 (the inverse of the number of pole pairs) and an imperfect differentiator 373 (inverse model of the machine device) to calculate the load torque TL. Incidentally, a time constant Tobs of denominator in the imperfect differentiator 373 is observer gain. It is possible to adjust the band of a frequency component included in TL by this time constant.

By using the state observer shown in Fig. 27, the generated torque Tm of the electric motor 1 and the load torque TL which are difficult to be detected directly can be determined using a mathematical model. For example, the torque vibration of the machine device, etc. can also be observed by the state observer 37. This can help state monitoring. Incidentally, the feature extractor 6N may perform processing such as the vibration component extraction, output, etc. which have been described thus far.

Further, as the model of the machine device, the various state amounts can be calculated by introducing a physical model as a more detailed mathematical model. This is available even for monitoring of the vibration of a vehicle body, the effectiveness of a suspension, or a road surface state, etc. by simulating the body of an automobile, for example.

By introducing the state observer inside the monitoring device as described above, the new state amounts such as the generated torque, the load torque, etc. can be determined by calculation, thus making it possible to help state monitoring.

### (Thirteenth Embodiment)

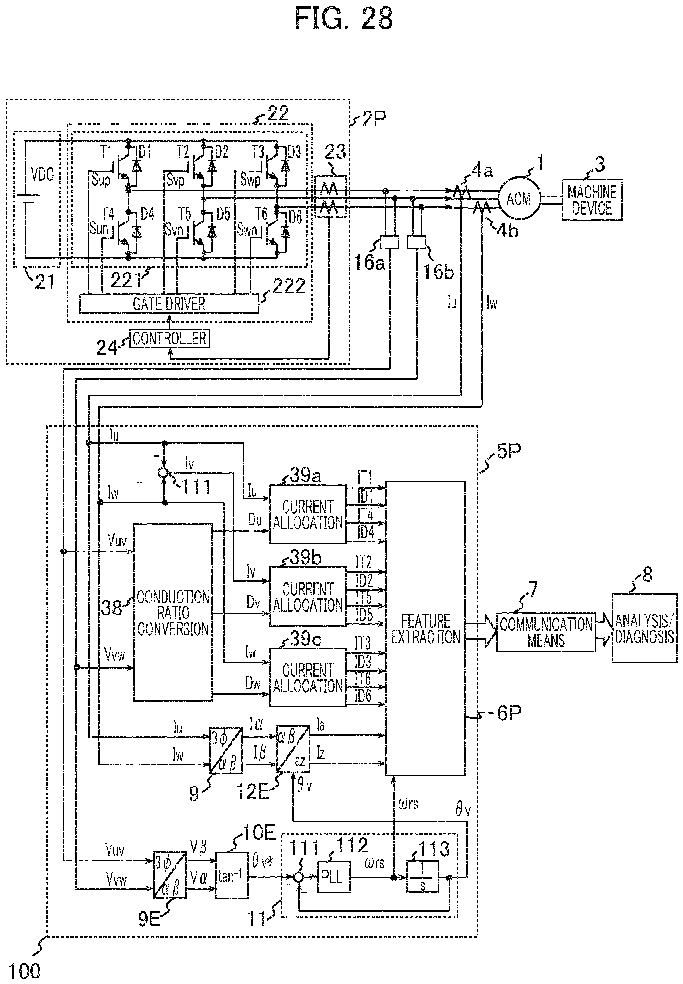

An electric motor drive system, an AC electric motor, and their monitoring device according to a thirteenth embodiment of the present invention will be described using Figs. 28 to 33.

Fig. 28 shows a block configuration diagram of the thirteenth embodiment.

Fig. 28 illustrates a configuration in which in the configuration of the fifth embodiment shown in Fig. 11, the details of a drive power supply 2P are described, and a monitoring device 5P is introduced instead of the monitoring device 5E.

The previous embodiments have been constructed mainly for the purpose of the state monitoring of the electric motor 1 and the machine device 3. However, the present embodiment is intended to monitor operating states of switching elements (T1 to T6 and D1 to D6) constituting an inverter main circuit.

In Fig. 28, the drive power supply 2P is comprised of a DC voltage source 21 of a voltage VDC, a three-phase full-bridge inverter main circuit unit 221, a gate driver 222 to give a gate signal to each switching element, a current sensor 23, and a controller 24.

The monitoring device 5P has a function of separating an alternating current to an active current and a reactive current, based on a voltage sensor as with the embodiment of Fig. 11. Further, the monitoring device 5P monitors the operating state of each switching element of the inverter main circuit unit 221. Functions newly added from the monitoring device 5E are as follows.

The monitoring device 5P is constituted of an adder 111 (operated as a subtractor here) which calculates a V-phase current from U-phase and W-phase currents, a conduction ratio converter 38 which converts an inter-line voltage to a conduction ratio (duty), current allocators 39a to 39c which assign the phase currents to the respective switching elements, and a feature extractor 6P which converts the outputs of these current allocators into feature amounts.

On the basis of the voltage applied to the electric motor 1 and the current flowing therethrough, the monitoring device 5P determines by calculation how much current flows to any of the switching elements of the inverter main circuit unit 221 to thereby monitor the power balance and monitor whether or not current concentration occurs.

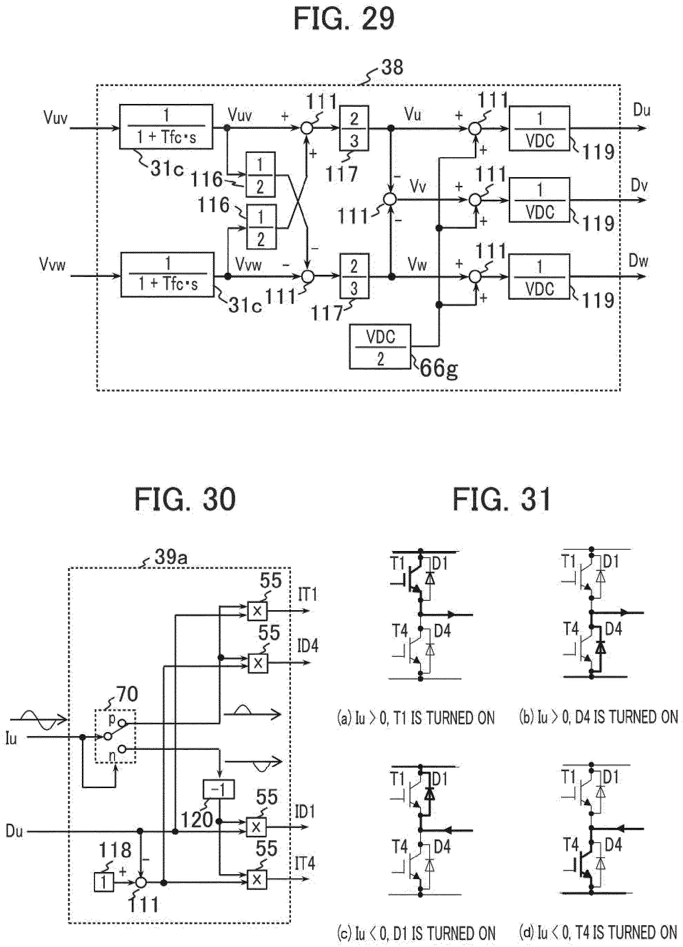

Fig. 29 shows an internal configuration of the conduction ratio converter 38. Since the inter-line voltages Vuv and Vvw are pulse voltages, pulse components thereof are removed by first-order lag filters of time constant Tfc and then they are converted to phase voltages. In Fig. 29, the calculation of (Numeral 7) through (Numeral 9) is performed using gains 116 and 117 and adders 111

Duty ratios Du to Dw are calculated by adding the value of 1/2 of the DC power supply to the resulting phase voltages Vu, Vv and Vw (performing setting by a constant setter 66g) and multiplying them by gains 119 (performing setting to 1/VDC). Consequently, Du to Dw varies in a range of 0.0 to 1.0. Incidentally, as in the sixth embodiment (Fig. 13), if it is possible to directly obtain the duty ratios Du to Dw from the controller 24, the conduction ratio converter 38 may be omitted.

Next, the operations of the current allocators 39a to 39c will be described using Figs. 30 and 31.

The respective current allocators 39a to 39c are equivalent to the arms of the respective phases of the inverter main circuit unit 221. If the U phase is taken, conduction currents of IGBT T1 and T4 and reflux diodes D1 and D4 are calculated.

In Fig. 30, the polarity of the phase current Iu is determined by a switch 70. If it is 'positive', the switch is changed to a p side, and if it is 'negative', the switch is changed to an n side. If the current is 'positive', there are two types where, as shown in Figs. 31(a) and (b), T1 being the upper IGBT is turned on, and the lower diode D4 is turned on. The proportion of current between T1 and D4 is determined by the duty Du of switching of the U-phase. Since the ratio at which T1 is turned on is proportional to Du, Iu and Du are multiplied by a multiplier 55 and its result is output as a current value IT1 of T1. Since a current of D4 is the remaining proportion of Du, 1-Du is determined by a constant setter 118 and the adder 111 (operated as a subtractor here), and Iu×(1-Du) is calculated by the multiplier 55 and output as ID4.

Similarly, when the phase current Iu is negative, as shown in Figs. 31(c) and (d), either D1 or T4 is turned on, and Du and (1-Du) are respectively multiplied to calculate a current ratio. Incidentally, since even the current of the negative side is assumed to be 'positive' for the switching element (the current flows only in one direction), the polarity of the negative-side current is reversed using a gain 120.

In this way, the phase current can be assigned to each of the respective switching elements.

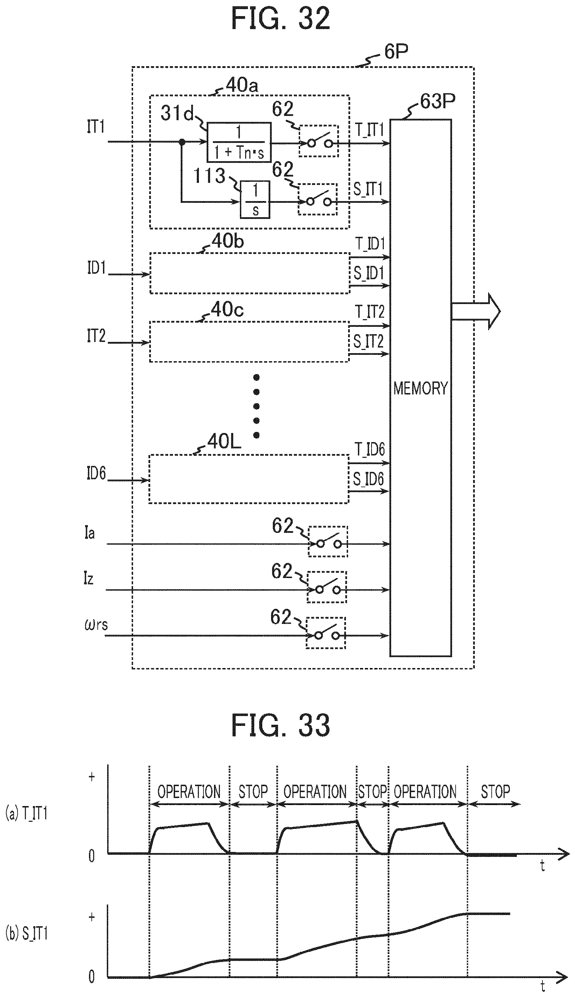

The current values IT1 to IT6 and ID1 to ID6 of the respective switching elements calculated in this way are converted into the feature amounts by the feature extractor 6P. Fig. 32 shows the configuration of the feature extractor 6P.

In the feature extractor 6P, device state monitoring units 40a to 40L are aligned and respectively calculate temperature-corresponding state amounts T_IT1 to 6 and T_ID1 to 6 and operation-history corresponding state amounts S_IT1 to 6 and S_ID1 to 6 of 12 pieces of switching elements. The configuration of the device state monitoring unit 40 is constituted of a first-order lag filter 31d of a time constant Tn, an integrator 113, and a sample switch 62. The first-order lag filter 31d is required to match the time constant with a temperature time constant of each switching element. By matching the time constant with the temperature time constant, the operating temperature of each device can be estimated and calculated. Also, viewed from another angle, it is possible to monitor whether an offset current flows in any device.

In general, the load characteristics of the machine device 3 often becomes three-phase balanced. However, for example, in the case where a reciprocating compressor or the like is driven, a load fluctuation occurs in the same cycle as the rotation cycle, and hence a load current is likely to concentrate on the particular switching element. Such an offset state can be monitored by this feature extractor.

Further, by integrating the current by the integrator 113, the history of the device can be saved. By accumulating and analyzing history data, it is possible to help life prediction of the device.

Fig. 33 shows an example of waveforms of the outputs T_IT1 and S_IT1 of the device state monitoring unit 40a. It can be seen that T_IT1 varies with the operation of the electric motor drive system. Further, it is possible to confirm a state of S_IT1 leaving a history by integrating an operating current.

### (Fourteenth Embodiment)

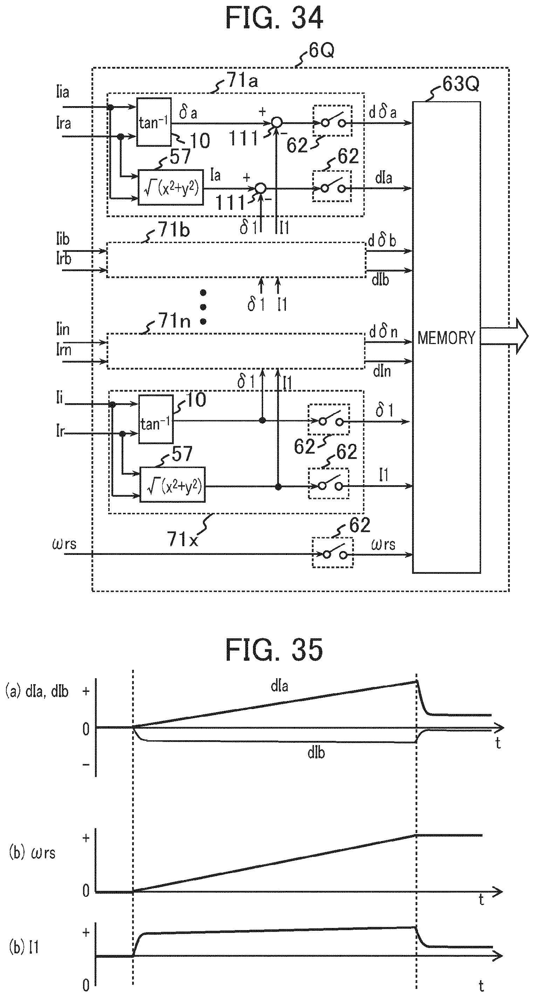

A monitoring device according to a fourteenth embodiment of the present invention will be described using Figs. 34 and 35.

Fig. 34 shows a block configuration diagram of the fourteenth embodiment.

The present embodiment can be realized by replacing the feature extractor 6C of the third embodiment shown in Fig. 7 with a feature extractor 6Q shown in Fig. 34.

In the third embodiment, the drive currents of the plural (n) electric motors have been subjected to the rotating coordinate conversion in the same phase to monitor the operating states of the individual electric motors. In the present embodiment, in order to clearly extract the difference in operating state between the n electric motors, the current of each electric motor is converted to extract a feature amount.

As shown in Fig. 34, the feature extractor 6Q is comprised of polar coordinate converters 71a to 71x each of which converts a current of a DC amount subjected to rotating coordinate conversion (transformation on the orthogonal coordinates of two axes) into polar coordinates, and a memory 63Q.

The polar coordinate converters 71a to 71x are respectively constituted of an arc tangent calculator 10, an AC absolute value calculator 57, an adder 111, and a sample switch 62, which are the parts described so far.

As described in the second embodiment, the currents of the respective electric motors are subjected to the rotating coordinate conversion based on the total current to obtain Ira to Irn and Iia to Iin respectively.

The polar coordinate converter 71x computes, in terms of Ir and Ii being the average current, an angle δ1 formed by the two at the arc tangent calculator 10, calculates I1 being the magnitude at the AC absolute value calculator 57, samples its value by the sample switch 62, and saves the same into the memory 63Q. The feature part of the present embodiment is that the feature amount of the current of each electric motor is determined based on δ1 and I1 obtained with the average current.

The differences between the average I1 and δ1 determined in the polar coordinate converter 71x and Ia to In and δa to δn calculated similarly by the respective electric motors are respectively calculated and stored in the memory 63Q as dIa to dIn and dδa to dδn. Since dIa to dIn and dδa to dδn are amounts shifted from the average value, it is possible to monitor how much the current amplitude is shifted, or how much the phase difference is generated. That is, the operating state of each AC electric motor can be calculated based on at least one of the phase of the current flowing through the AC electric motor and the amplitude thereof.

Fig. 35 shows a waveform example of these feature amounts.

In Fig. 35, a drive frequency ωrs is increased, the electric motor is in a state of being accelerated, and the average current amplitude I1 is increased slightly but does not change greatly. It can however be seen that dIa is increased in proportion to the speed, and dIb has a constant deviation without depending on the speed. From this view, the electric motor 1a can determine that an error proportional to the rotational speed is being generated. That is, the operating state of each AC electric motor can be separately calculated. In terms of the error proportional to the rotational speed, it is considered that in the case of an electric motor for a railway vehicle, a difference in wheel diameter occurs, and only the electric motor 1a is increasing in load with the rotational speed. Further, it is considered that an electric motor 1b having an almost constant error without depending on the load has a possibility that an error occurs in the constant.

Thus, according to the present embodiment, the electric motor drive system which drives the plurality of electric motors with one drive power supply is capable of separating the differences in operating state between the respective electric motors and outputting the feature amount. It is thus possible to help state monitoring.

### (Fifteenth Embodiment)

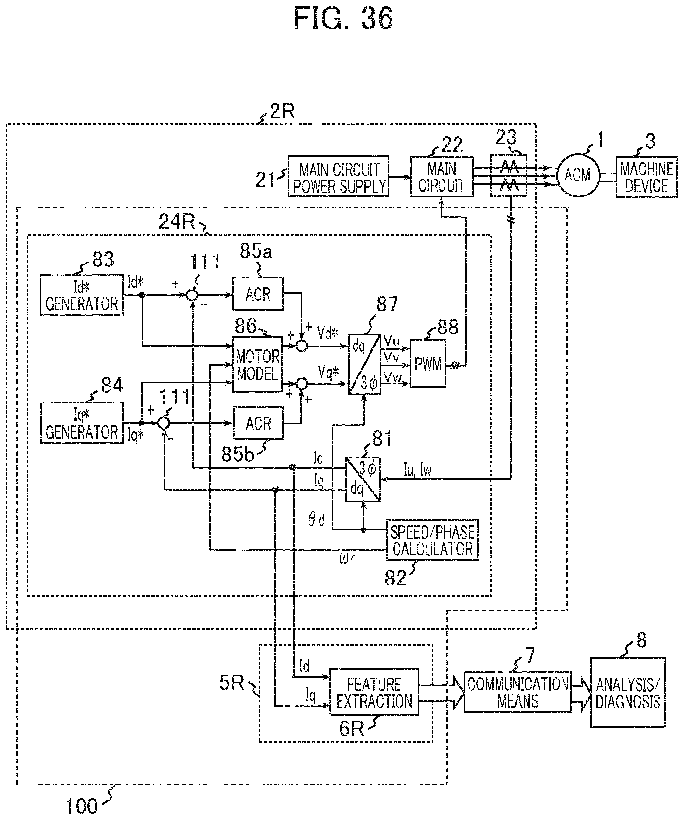

An electric motor drive system, an AC electric motor, and their monitoring device according to a fifteenth embodiment of the present invention will be described using Fig. 36.

The present embodiment resides in that in the configuration diagram of the sixth embodiment shown in Fig. 13, the controller 24 is replaced with a controller 24R shown in Fig. 36 and further Id and Iq being internal state amounts of the controller 24R are drawn to the outside, and feature extraction is performed in a monitoring device 5R. The monitoring device 5R is comprised of a feature extractor 6R. Then, state monitoring is performed by a analysis/diagnosis device 8 through a communication means 7.

A drive power supply 2R performs vector control of an electric motor 1, and the details of its operation are described in the controller 24R of Fig. 36.

In the controller 24R, the phase current of the electric motor 1 is detected by a current sensor 23 provided inside the drive power supply 2R and then converted into a DC amount using a phase angle θd at a dq coordinate converter 81. θd used for coordinate conversion is calculated in a speed/phase calculator 82. Incidentally, Fig. 36 shows the configuration of speed-position sensorless control not using the rotation shaft sensor in the electric motor 1, but there is no problem even if these sensors are used.

In the dq coordinate converter 81, the phase current of the electric motor 1 is converted into the currents Id and Iq on the d- and q-axes each being a DC amount, which are respectively used for vector control. In terms of the d-axis current Id, the difference between the d-axis current Id and a d-axis current command Id* output from an Id* generator 83 is calculated by an adder 111, and controlled by a current controller (ACR) 85a such that the deviation therebetween becomes zero. Similarly, in terms of the q-axis current Iq, the difference between the q-axis current Iq and a q-axis current command Iq* output from an Iq* generator 84 is calculated by an adder 111, and controlled by a current controller (ACR) 85b so that the deviation therebetween becomes zero. Further, a motor model calculator 86 performs voltage operation by a mathematical model based on the constants of the electric motor 1, and adds its outputs to the outputs of the respective ACR 85a and 85b to calculate voltage commands Vd* and Vq* of the d and q axes. The voltage commands Vd* and Vq* are converted into three-phase AC voltages at a dq inverse converter 87, and then converted into a pulse train by a PWM (pulse width modulation) generator 88, thereby driving an inverter of a main circuit. The current controller executes control so that the deviation becomes zero on the rotating coordinate axes synchronized with the AC voltage output from the drive power supply.

Incidentally, each of the Id* generator 83 and the Iq* generator 84 means a command generator in the upper order of the current controller. For example, it is a block including a speed controller (ASR) or the like controlling the speed of the electric motor 1.

As described above, the drive power supply in the electric motor drive system often constitutes a vector control system as shown in Fig. 36. In that case, the controller often performs control thereinside by converting the alternating current into the DC amount once. The present embodiment is characterized by diverting the coordinate conversion in the controller 24R and retrieving the DC amount after the conversion thereof to the outside. At this time, the controller 24R transmits the values of Id and Iq to the monitoring device 5R by performing serial or parallel communications, or conversion to an analog value, etc. In the external monitoring device 5R, the feature extractor 6R executes extraction of a feature amount with respect to the received Id and Iq. Thus, if it is possible to utilize the amount of an internal state of the controller 24R, the operation of the monitoring device 5R becomes very simple, thereby making it possible to greatly reduce a processing load factor of the feature extractor 6R and utilize an inexpensive microcomputer.

Moreover, there is also an advantage that the reduction in the calculation load factor of the microcomputer enables the extraction of various feature amounts to be executed simultaneously. For example, the algorithms of the feature extractors in Figs. 14, 16, 17, 19, etc., described thus far are processed in parallel to make it also possible to enhance monitoring. Further, even if the control internal state amount other than Id and Iq, e.g., ωr or the like is drawn to the outside, no problem occurs.

As described above, according to the present embodiment, the control internal state amount of the electric motor drive system is drawn to the outside, thereby making it possible to reduce the load of the monitoring device, and further achieve monitoring by conversion to the various feature amounts.

### (Sixteenth Embodiment)

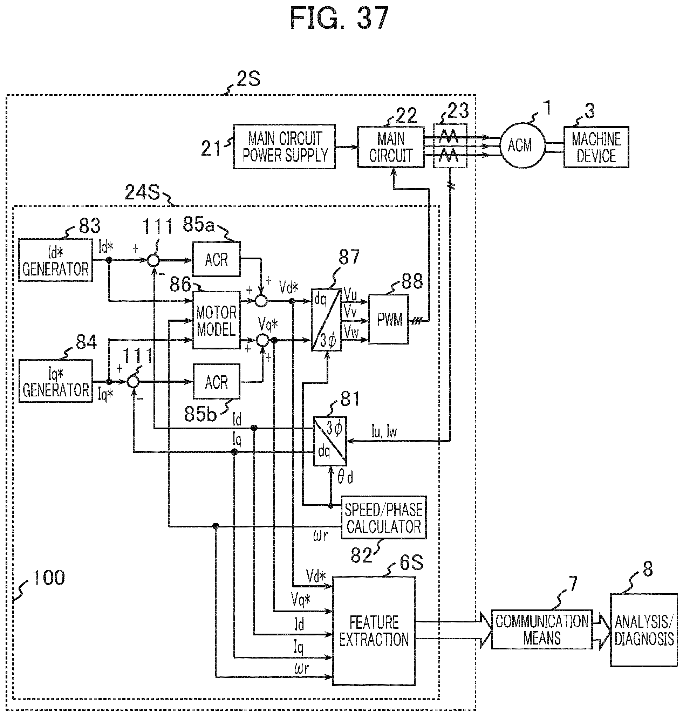

An electric motor drive system, an AC electric motor, and their monitoring device according to a sixteenth embodiment of the present invention will be described using Fig. 37.

The present embodiment resides in that in the configuration diagram of the fifteenth embodiment shown in Fig. 36, the controller 24R is replaced by a controller 24S shown in Fig. 37, the monitoring device 5R is eliminated, and instead a feature extractor 6S is installed inside the controller 24S. A feature part of the present embodiment resides in that the role of the monitoring device is included in a drive power supply 2S. Therefore, the output of the feature extractor 6S is transferred through a communication means 7 directly from the drive power supply 2S to an analysis/diagnosis device 8.

If the drive power supply 2S is provided thereinside with a monitoring function, i.e., the controller and the feature extractor 6S being a feature extracting means are operated on a signal processing device in which they are integrated, adverse effects to communications are eliminated, and more internal amounts can be utilized.

Ass shown in Fig. 37, for example, since state amounts such as voltage commands Vd* and Vq*, a rotational speed ωr, etc. can also be utilized, the calculation of active/reactive power shown in Fig. 23, the use of the observer shown in Fig. 25, the monitoring of the switching element shown in Fig. 28, etc. can also be mounted simultaneously.

In that case, the calculation load factor of the controller 24S increases, but if design such as using a recent multi-core microcomputer, sharing a bus in multiple microcomputers, etc. is performed, the implementation of such an algorithm is easy. Of course, it is necessary to take substantial review of a software structure for the existing device. However, the above is a very effective means when developing a drive power supply with a premonitoring function.

According to the present embodiment as described above, it is possible to extract various feature amounts without drawing the internal amount of the electric motor drive system to the outside. That is, using at least either the current value on the rotating coordinate axes used in the controller or the voltage value on the rotating coordinate axes as the DC amount, the feature extractor outputs the feature amount on the basis of at least one of any DC amount and the rotational speed used in the controller. It is thus possible to realize the monitoring of the electric motor drive system.

### (Seventeenth Embodiment)

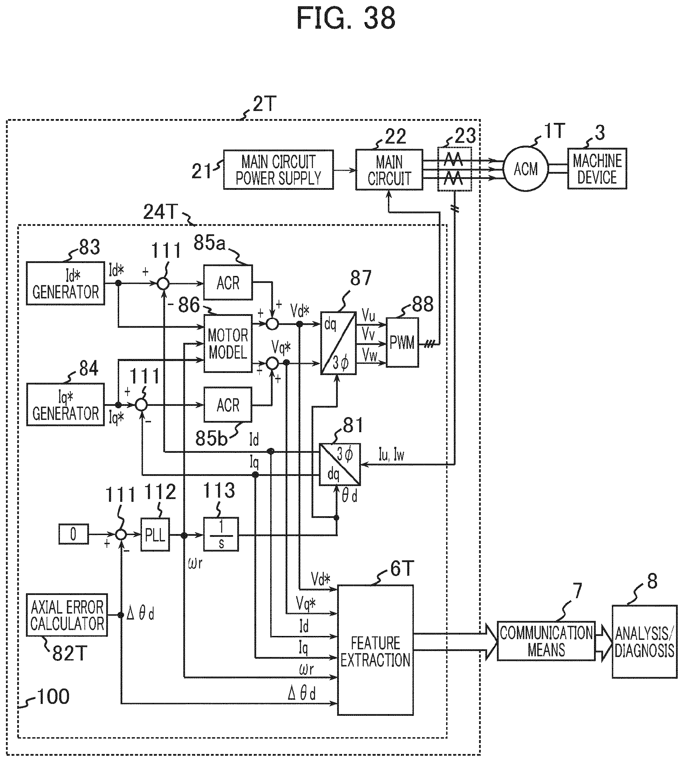

An electric motor drive system, an AC electric motor, and their monitoring device according to a seventeenth embodiment of the present invention will be described using Fig. 38.

The present embodiment resides in that in the configuration diagram of the sixteenth embodiment shown in Fig. 37, the controller 24S is replaced by a controller 24T shown in Fig. 38, and further constitutes position sensorless control not using the rotation shaft sensor with the electric motor 1 as a permanent magnet electric motor 1T.

As a block configuration diagram, in order to perform the position sensorless control of the permanent magnet electric motor, an axial error calculator 82T is introduced instead of the speed/position calculator 82 in Fig. 37, and further adders 111, a PLL controller 112, and an integrator 113 are added. Moreover, the feature extractor 6S is changed to a feature extractor 6T.

As the position sensorless control of the permanent magnet electric motor, there are various methods. There is however often used a method of calculating a deviation (it is assumed to be an axial error Δθd) between an actual rotor position θd of the electric motor, and a phase angle estimated inside the controller 24T, and controlling its value in such a manner that the value becomes zero.

The controller 24T in Fig. 38 shows its example. In the axial error calculator 82T, the axial error occurring between the electric motor and the controller is calculated, and the adder 111 and the PLL controller 112 are used to calculate a drive frequency ωr of the electric motor so that the value of the axial error becomes zero. By adjusting ωr, the control internal phase θd is adjasted, thereby controlling the axial error Δθd to zero.

In this position sensorless control system, the internal amount called the 'axial error Δθd' is a very important value, and the generated amount of this deviation is intended to determine the stability of the system. In the steady state, Δθd is controlled to zero, but at the time of a transient response, the time of occurrence of a constant error, etc., there is a case where a deviation occurs in Δθd. This is because, as its major factor, a response delay related to a control response occurs inevitably where a load change occurs (primarily, the operation related to setting gain of the PLL controller 112). If paradoxically grasped, it is possible to infer from the movement of Δθd at the load change, what kind of load change has occurred. Further, it is considered that even if there is no change in load itself, a change occurs in the movement of Δθd even where motor parameters and mechanical parameters change due to aging.

Therefore, the monitoring of Δθd is extremely important. If the feature extractor 6T performs the conversion thereof to the feature amount and its monitoring on the basis of the axial error, it is possible to quickly detect changes of the electric motor and the machine device, and the sign of abnormality. The feature extractor 6T carries out analysis of a variation component of the axial error Δθd and frequencies, etc. through the various algorithms described in the previous embodiments. That is, the feature extractor 6T outputs the feature amount on the basis of the axial error. It is thus possible to more quickly an abnormal state. Further, an important variable is obtained as a factor to perform analysis/diagnosis.

According to the present embodiment as described above, in the electric motor drive system using the position sensorless permanent magnet electric motor, the monitoring device can be realized which is capable of improving detection accuracy with respect to aging, abnormal operations, or the sign of abnormality.

### (Eighteenth Embodiment)

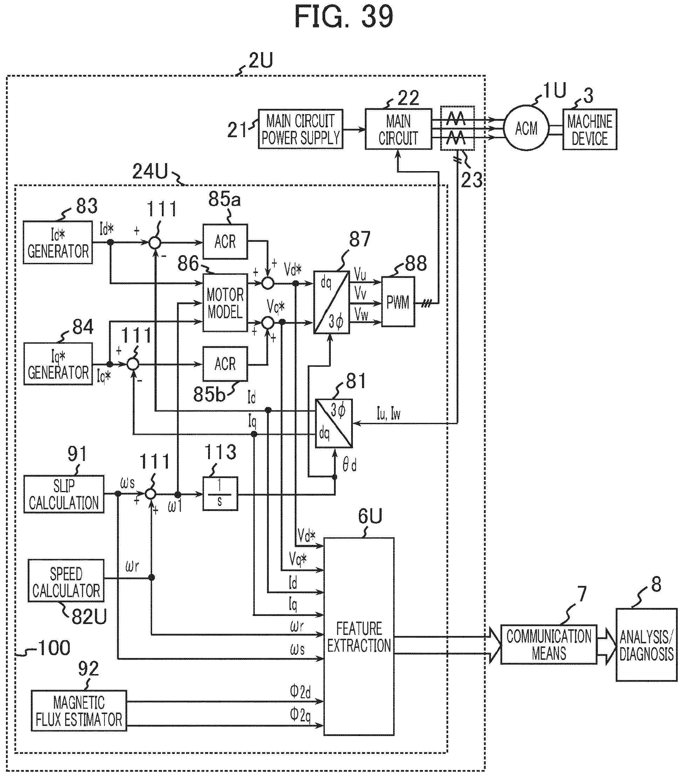

An electric motor drive system, an AC electric motor, and their monitoring device according to an eighteenth embodiment of the present invention will be described using Fig. 39.

The present embodiment resides in that in the configuration diagram of the sixteenth embodiment shown in Fig. 37, the controller 24S is replaced by a controller 24U shown in Fig. 39, and configures speed sensorless control not using the rotation shaft sensor with the electric motor 1 as an induction electric motor 1U.

As a block configuration diagram, in order to perform the speed sensorless control of the induction electric motor, a speed calculator 82U is introduced instead of the speed/position calculator 82 in Fig. 37, and further a slip frequency calculator 91 and a magnetic flux estimator 92 are added. Moreover, the feature extractor 6S is changed to a feature extractor 6U.

As the speed sensorless control of the induction electric motor, there are various methods, but the speed calculator 82U estimating an actual rotational speed ωr of the electric motor, and the slip calculator 91 calculating a sip frequency ωs of the induction electric motor become important blocks. Further, unlike the permanent magnet electric motor, it is necessary to control a magnetic flux by an excitation current (Id). ϕ2d being its d-axis magnetic flux is controlled constant, and ϕ2q being a q-axis magnetic flux is controlled to be zero. In principle, by adjusting the slip frequency ωs to the torque of the electric motor, ϕ2d can be controlled constant, and ϕ2q can be controlled to zero. The torque can be made proportional to ϕ2d×Iq.

Conversely, when ϕ2d varies and further ϕ2q is generated, the value of the slip frequency ωs is not appropriate. In the present embodiment, the magnetic flux estimator 92 is introduced to perform magnetic flux estimation operation of the inside of the induction electric motor, and the feature extractor 6U performs extraction of a feature amount. By performing monitoring of such a state amount, it is possible to separate variations, for example, depending on whether the slip frequency ωs and the magnetic fluxes ϕ2d and ϕ2q fluctuate with a phase relationship or they are independent of each other. If they fluctuate with the correlation, there is a high possibility that the load itself of the machine device is fluctuating. If there is no correlation in reverse, the possibility of a constant fluctuation of the induction electric motor is considered. Thus, by monitoring the control internal amount of the induction electric motor, separation when an abnormal operation is detected can be performed.

According to the present embodiment as described above, in the electric motor drive system using the speed sensorless induction electric motor, the monitoring device can be realized which is capable of improving detection accuracy with respect to aging, abnormal operations, or the sign of abnormality.

### (Nineteenth Embodiment)

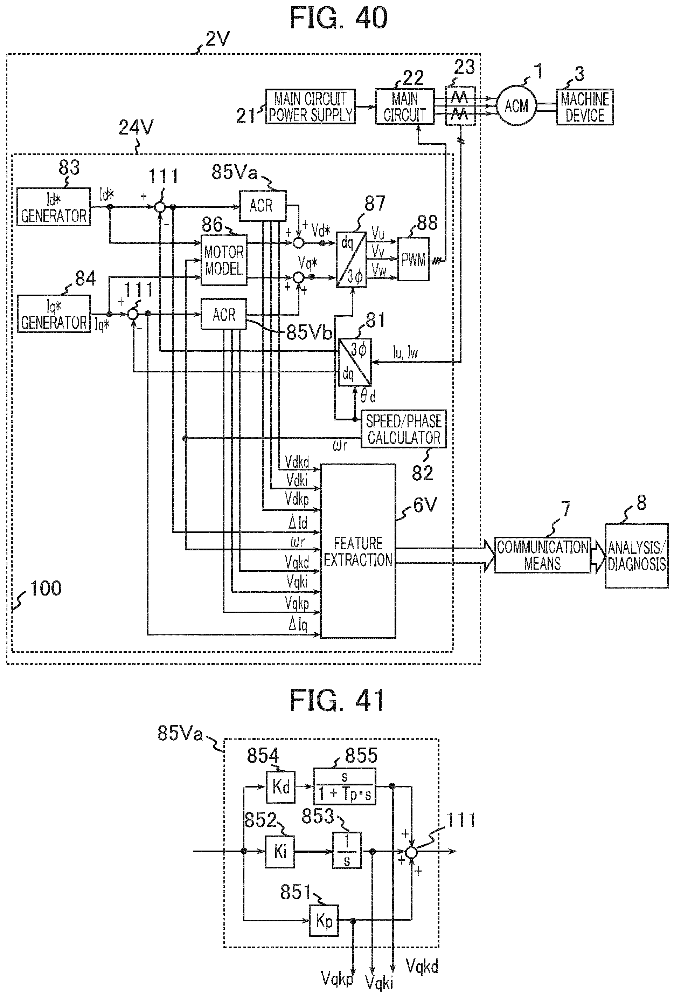

An electric motor drive system, an AC electric motor, and their monitoring device according to a nineteenth embodiment of the present invention will be described using Fig. 40.

The present embodiment resides in that in the configuration diagram of the sixteenth embodiment shown in Fig. 37, the controller 24S is replaced by a controller 24V shown in Fig. 40. In the controller 24V, current controllers 85Va and 85Vb and a feature extractor6V are changed.

The configuration of each of the current controllers 85Va is shown in Fig. 41. Generally, the current controller constitutes a PID controller similarly even in the present embodiment though PI control (proportional integral control) or PID control (proportional-integral-derivative control) is performed. In Fig. 41, the current controller 85Va is comprised of a proportional gain 851, an integral gain 852, an integrator 853, and a differential gain 854, an incomplete derivative element 855 of a time constant Tp, and an adder 111. Further, Vdkp, Vdki, and Vdkd each being the output of each compensator are to be drawn to the outside of a block. The q-axis current controller 85Vb is also similar in configuration and serves to draw outputs Vqkp, Vqki, and Vqkd of respective compensators to the outside of a block. The internal amounts of these controllers, and further ΔId (=Id*-Id) and ΔIq (=Iq*-Iq) each being a current deviation are input to the feature extractor 6V to extract feature amounts.

Since the current controller is generally operated to set the deviation (ΔId, ΔIq) to zero, ΔId and ΔIq in the steady state converge to zero. However, though the value is generated in a transient state such as at the time of a command change and a load change, the movement at the time of transition changes with the state of the electric motor 1, machine device 3 or main circuit power supply 21. That is, 'abnormality' or 'sign of abnormality' undetectable in the steady state can be monitored from the movement of the deviation of the controller.

Further, since the current controllers 85Va and 85Vb are for performing proportion, integration and differentiation on these current deviations, the influence of the deviation occur even herein. In particular, the output of the integrator is placed in a relationship which occurs even steadily.

For example, a motor model calculator 86 calculates the voltage required in the steady state as feedforward. However, if the parameter in it deviates from the actual electric motor, its shift amount is steadily compensated by integral compensation of the current controller. Therefore, factors for constant fluctuation steadily occur in Vdki and Vqki. Further, since the response of the current control is determined by a proportional gain kp and a differential gain Kd, it is desirable to monitor the outputs of these compensators and monitor the transient feature amount for detecting the abnormal operation during transition.

Therefore, it can be said that it is extremely beneficial to extract the feature amount from the internal amounts of these current controllers and the current deviations.

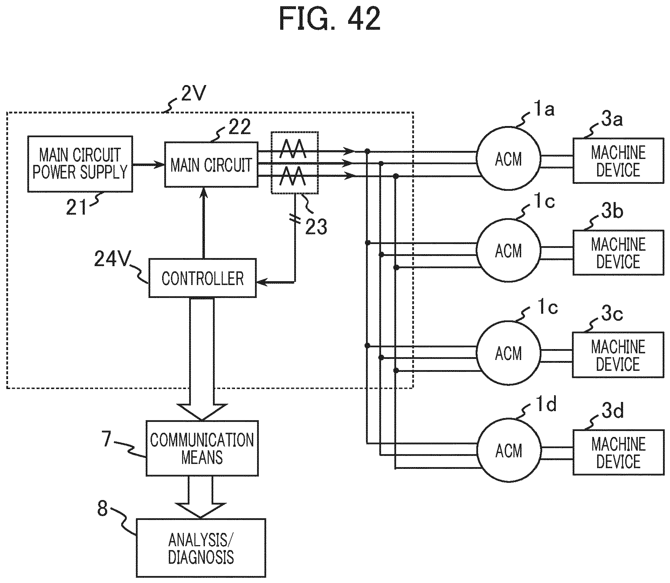

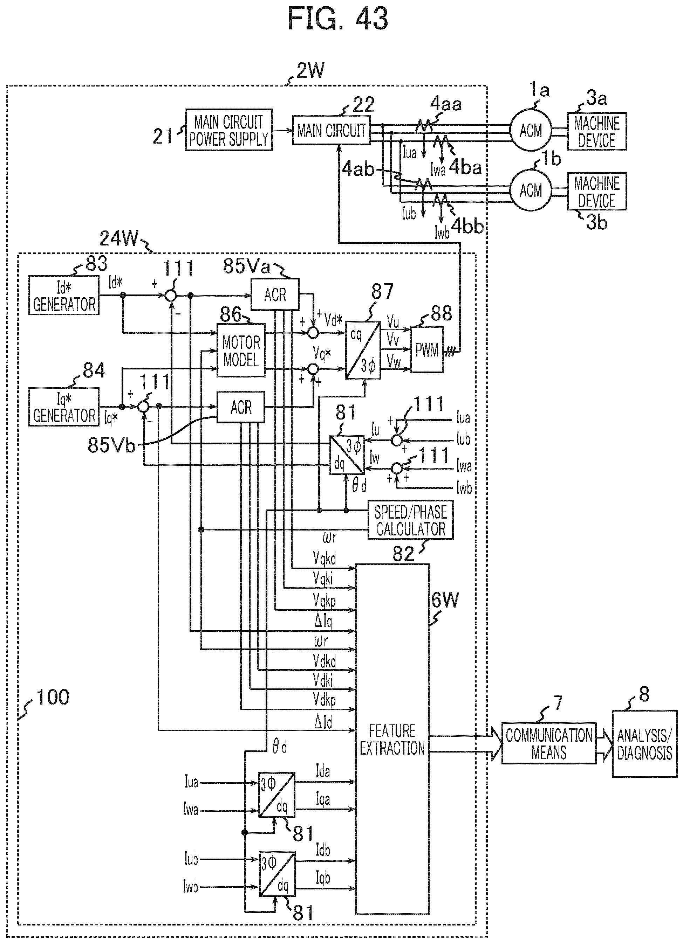

Fig. 42 and Fig. 43 show an application example of the present embodiment.

Fig. 42 is an example in which a plurality of electric motors and machine devices (four in Fig. 42) are connected in parallel. Even in the case where parallel-drivable AC electric motors such as induction electric motors are parallel-driven in this way, the present embodiment is effective in abnormality detection. For example, when only any of the four electric motors generates heat, the resistance value of the electric motor is increased, and hence a parameter value varies slightly. As a result, since the output of the integral compensation of the current controller varies, any of the four is abnormal, which can be detected by monitoring the value thereof.

Further, Fig. 43 is an example in which two electric motors and machine devices are connected. However, here, current sensors are provided in the respective electric motors. A value obtained by adding them is used for control, and individual coordinate conversion is used in monitoring a current value. In the second embodiment, there has been shown the example in which the monitoring device 5C is installed aside from the controller. However, by integrating the monitoring device with the controller in this manner, the internal phase θd of the controller can be utilized, thereby making it possible to monitor the current on the dq-axis for each electric motor. It is possible to infer whether any electric motor is abnormal, from a change in the value of each individual current and a change in the internal amount of each current controller. Incidentally, Fig. 41 illustrates a case where the electric motors are two as an example, but it is possible to perform monitoring similarly even in the case of three or more electric motors.

According to the present embodiment as described above, in the electric motor drive system, the feature amount is extracted on the basis of the current deviation and the state amount obtained by performing proportion, integration, and differentiation on the current deviation, whereby it is possible to enhance the detection accuracy inclusive of transition and steadiness with respect to aging, an abnormal operation, or the sign of abnormality.

### (Twentieth Embodiment)

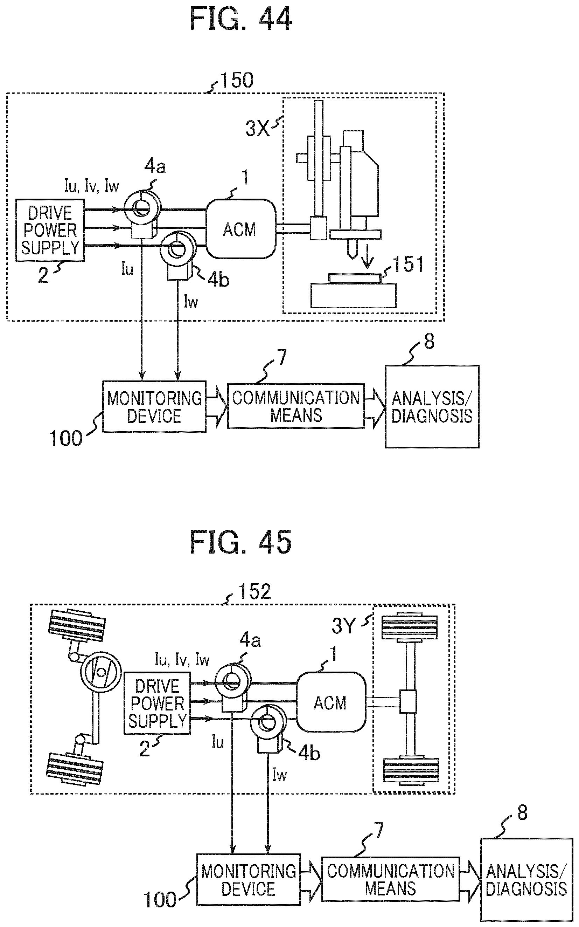

An electric motor drive system, an AC electric motor, and their monitoring device according to a twentieth embodiment of the present invention will be described using Fig. 44.

The present embodiment shows an example in which a part of the embodiments described so far is applied for industrial equipment.

Fig. 44 is an example in which the motor drive system is applied to a machine tool 150. As a machine device 3X, a cutting machine is connected to a rotating shaft of an electric motor 1. Fig. 44 shows a machine for performing machining to a material 151.

Current sensors 4a and 4b are installed for the machine tool 150, and their currents are input to a monitoring device 5, where the conversion of the alternating current which has been described so far is performed to monitor it. A feature amount is analyzed by an analysis/diagnosis device 8 via a communication means 7.

With such a configuration, the feature amount can be made useful for monitoring of the consumables of the machine tool, quality control of a workpiece 151, and the improvement of yields. Incidentally, regardless of the cutting machine, it can be expanded even to other machining apparatuses such as an electric pressing machine, an injection molding machine, etc. Further, its application to industrial equipment like a fan, a pump, and a compressor is also considered.

Incidentally, Fig. 44 has shown an example of the embodiment, but there is no problem even in combination with other embodiments described so far.

### (Twenty-First Embodiment)

An electric motor drive system, an AC electric motor, and their monitoring device according to a twenty-first embodiment of the present invention will be described using Fig. 45.

The present embodiment shows an example in which a part of the embodiments described so far is applied to an electric vehicle 152. In Fig. 45, a machine device 3Y is connected to driving wheels of the electric vehicle. Current sensors 4a and 4b are installed, and their currents are input to a monitoring device 5, where the conversion of the alternating current which has been described so far is performed to monitor it. A feature amount is analyzed by an analysis/diagnosis device 8 via a communication means 7.

With such a configuration, the feature amount can be made useful for monitoring of the state of a drive system, deterioration of bearings, the wear of each tire, and a road surface state, etc. Further, it is also possible to provide a service of analyzing the waste of power consumption from long-term data and advising a driver, etc.

As shown in Fig. 45, there is an advantage that the integration of the monitoring device with the drive power supply 2 rather than installing the monitoring device in the vehicle as in the case of the embodiments such as shown in the fifteenth to eighteenth embodiments makes it possible to perform monitoring without ensuring an installation place.

Incidentally, Fig. 45 shows an example of the embodiment, but there is no problem even in combination with other embodiments described so far.

### (Twenty-Second Embodiment)

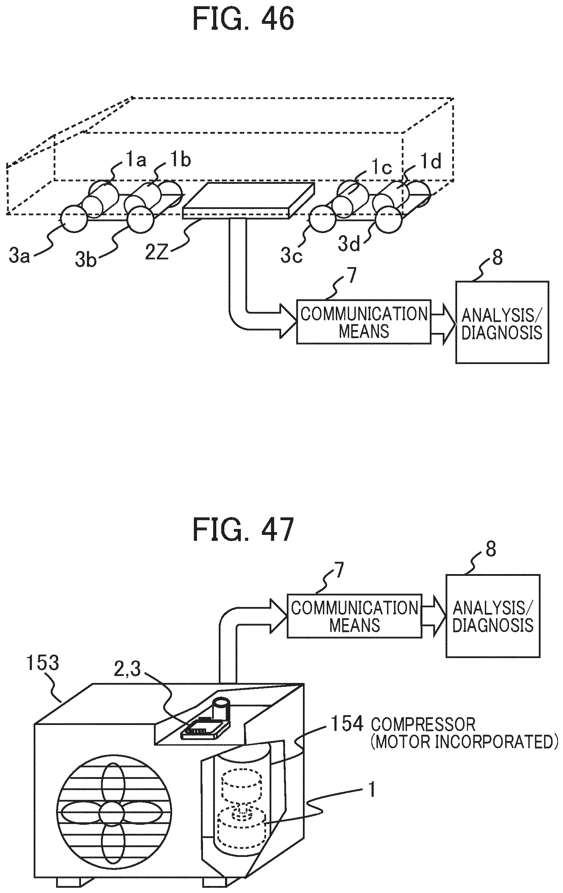

An electric motor drive system, an AC electric motor, and their monitoring device according to a twenty-second embodiment of the present invention will be described using Fig. 46.

The present embodiment shows an example in which the nineteenth embodiment (Fig. 42) is applied to an electric railway vehicle. In Fig. 46, a plurality of electric motors 1a to 1d are connected to a drive system of the electric railway vehicle. Further, even other than the embodiment of Fig. 42, for example, it is possible to monitor each electric motor by using Fig. 7, Fig. 34, Fig. 43, etc. The resulting feature amount is analyzed by an analysis/diagnosis device 8 via a communication means 7.

With such a configuration, the feature amount can be made useful for monitoring of the state of a drive system, deterioration of bearings, the wear of each wheel, and the state of a track, etc. Especially, since it is possible to determine whether there is a risk of abnormality in any electric motor with respect to a plurality of electric motors, it is possible to save labor for maintenance work. Also, the aging of a mechanical system can be monitored from long-term data, and a change in the ambient temperature can also be monitored from the behavior of a current waveform of the electric motor. Further, it is also possible to provide a service of analyzing a change in power consumption and advising a driver, etc.

When the monitoring device is installed in the railway vehicle, the integration of the monitoring device with the drive power supply 2 rather than separately installing the monitoring device as in the case of the embodiments such as shown in the sixteenth to nineteenth embodiments makes it possible to use an installation space without being wasted.

Incidentally, Fig. 46 shows an example of the embodiment, but there is no problem even in combination with other embodiments described so far.

### (Twenty-Third Embodiment)

An electric motor drive system, an AC electric motor, and their monitoring device according to a twenty-third embodiment of the present invention will be described using Fig. 47.

The present embodiment shows an example in which the embodiments described so far are applied to a household electrical appliance. In Fig. 47, monitoring is performed with a compressor 154 of an air conditioner 153 as a machine device. With such a configuration, a feature amount can be made useful for monitoring of the driving state of the compressor, the deterioration of bearings, and the leakage of a refrigerant, etc.

It is also possible to provide a service of being capable of monitoring aging of a mechanical system from long-term data, and of analyzing a change in power consumption to advise a maintenance period, etc.

Even in the present embodiment, the integration of the monitoring device with the drive power supply 2 rather than separately installing the monitoring device as in the case of the embodiments such as shown in the seventeenth to twentieth embodiments makes it possible to use an installation space without being wasted.

Incidentally, Fig. 47 shows an example of the embodiment, but there is no problem even in combination with other embodiments described so far.

Also, as mentioned above, the monitoring device of the AC electric motor of the present invention is capable of not only monitoring the behavior of the AC electric motor, but also monitoring the behavior of the electric motor drive system including the drive power supply and machine device which are connected to the AC electric motor. For example, since the behavior of the machine device connected to the AC electric motor appears even in the current value of the AC electric motor, the monitoring of the machine device connected to the AC electric motor and the electric motor drive system can also be performed together by performing the monitoring of the AC electric motor.

Although the embodiments of the present invention have been specifically described above, the present invention is not limited to the above embodiments. As described above, the present invention is a technique of realizing state monitoring of aging and abnormal detection, etc. of the electric motor drive system with the AC electric motor as power with high accuracy and in the minimum data quantity. The range of application for this technique is available from industrial applications such as a machine tool, a spindle motor, a fan, a pump (hydraulic pump, water pump), a compressor, a heating/cooling apparatus, etc. to an electric vehicle and a motor for a railway vehicle or the like.

### List of Reference Signs

1...three-phase AC electric motor, 2...drive power supply, 3...machine device, 4...current sensor, 5...monitoring device, 6...feature extractor, 7...communication means, 8...analysis/diagnosis device, 51...zero-cross measuring instrument, 52...frequency calculator, 53...SIN wave generator, 54...COS wave generator, 55...multiplier, 56...low pass filter, 57...AC absolute value calculator, 100...monitoring apparatus.

## Claims

1. A monitoring device (100) for installation in an electric motor drive system, which monitors an AC electric motor (1) driven by a drive power supply (2) or a device connected to the AC electric motor,
wherein the monitoring device is configured to:
convert a current detection value of at least two phases of the AC electric motor detected by current detecting means (4) of the AC electric motor into alternating currents of orthogonal two phases,
convert the alternating currents of the orthogonal two phases into a DC amount by performing coordinate conversion of the alternating currents of the orthogonal two phases,
extract a feature amount on the basis of the DC amount, and
output the feature amount to an external analysis/diagnosis device (8) which analyzes a state of the AC electric motor or the device connected to the AC electric motor based on time-series data of the feature amount,
**characterized in that** the device is further configured to:
determine a coordinate conversion phase θi by calculating an alternating current phase angle θi* between the alternating currents of the orthogonal two phases, and
perform the coordinate conversion of the alternating currents of the orthogonal two phases using the determined coordinate conversion phase.

2. The monitoring device (100) according to claim 1, wherein calculating the alternating current phase angle θi* comprises:
using an arctangent calculator to calculate an alternating current phase angle θi* according to: ${θ}_{i}^{∗} = {tan}^{- 1} \frac{{I}_{β}}{{I}_{α}}$ wherein *I_{β}* and *I_{α}* are the alternating currents of the orthogonal two phases.

3. The monitoring device (100) according to claim 2 wherein calculating the coordinate conversion phase further comprises:
using a phase calculator 11 to calculate the coordinate conversion phase θi relative to the alternating current phase angle θi* by performing proportional integral control on a deviation between the alternating current phase angle θi* and the coordinate conversion phase θi.

4. The monitoring device (100) according to claim 3 wherein the phase calculator 11 comprises:
an adder 111 configured to calculate the deviation between the alternating current phase angle θi* and the coordinate conversion phase θi being the output of the phase calculator 11;
a PLL controller 112 which performs the proportional integral control on the deviation and outputs an angular frequency ωrs; and
an integrator 113 configured to calculate the coordinate conversion phase θi by integrating the angular frequency ωrs.

5. The monitoring device (100) for the electric motor drive system according to claim 1, wherein the feature amount is output to the analysis/diagnosis device (8) via a communication unit (7) configured by a wired or a wireless communication network.

6. The monitoring device (100) for the electric motor drive system according to claim 1, wherein the feature amount is stored in a memory (63) for output to the analysis/diagnosis device.

7. The monitoring device (100) for the electric motor drive system according to any one of claims 1 to 5, wherein a plurality of the AC electric motors (1) are connected in parallel to one drive power supply (2), and the current detecting means (4) detect a current of each of the plurality of the AC electric motors and/or an output current of the drive power supply.

8. The monitoring device (100) for the electric motor drive system according to claim 7, wherein when the plurality of the AC electric motors (1) are driven by the one drive power supply, the monitoring device converts the current detection values of the plurality of AC electric motors into the DC amounts respectively by using a common coordinate conversion phase θi and an angular frequency ωrs calculated from a total value of the current supplied from the drive power supply.

9. The monitoring device (100) for the electric motor drive system according to claim 1, wherein the monitoring device converts the current detection value into the DC amount on the basis of a position of a rotating shaft of the AC electric motor (1) or a speed thereof detected by rotating shaft measuring means (14) of the AC electric motor.

10. The monitoring device (100) for the electric motor drive system according to claim 1, wherein the monitoring device converts the current detection value into the DC amount on the basis of a voltage detected by voltage detecting means (16) detecting a voltage applied to the AC electric motor (1).

11. The monitoring device (100) for the electric motor drive system according to claim 1, wherein the monitoring device converts the current detection value into the DC amount on the basis of phase information of the drive power supply, the phase information being an internal phase of the drive power supply used for vector control of the AC electric motor.

12. The monitoring device (100) for the electric motor drive system according to any one of claims 1 to 11, wherein the monitoring device uses one or more filters to extract a vibration component contained in the current detection value and output the vibration component as a value of the DC amount and extract the feature amount on the basis of the vibration component.

13. The monitoring device (100) for the electric motor drive system according to any one of claims 1 to 11, wherein using a frequency used when converting the current detection value into the DC amount, the monitoring device frequency-analyzes a pulsating component contained in the current detection value at an integer order or a fraction order and extracts the feature amount on the basis of a result of the frequency analysis.

14. The monitoring device (100) for the electric motor drive system according to any one of claims 1 to 11, wherein when the DC amount changes beyond a range of a predetermined value, the monitoring device analyzes at least one of an amount of variation in the DC amount and an amount of variation in a frequency used when converting the current detection value into the DC amount and extracts the feature amount on the basis of a result of the analysis.

15. The monitoring device (100) for the electric motor drive system according to any one of claims 1 to 11, wherein when the frequency used when converting the current detection value into the DC amount changes beyond a predetermined range, the monitoring device analyzes at least one of an amount of variation in a frequency and an amount of variation in the DC amount and extracts the feature amount on the basis of a result of the analysis.

16. The monitoring device (100) for the electric motor drive system according to any one of claims 1 to 11,
wherein at least one kind of external sensor of vibration, pressure, noise, temperature or humidity is attached to the electric motor drive system, and
wherein the monitoring device analyzes a correlation between information from the at least one kind of external sensor information and the DC amount and extracts the feature amount on the basis of a result of the analysis.

17. The monitoring device (100) for the electric motor drive system according to claim 10 or 11, wherein the monitoring device calculates at least one of instantaneous active power and instantaneous reactive power on the basis of the DC amount and extracts the feature amount on the basis of a result of the calculation.

18. The monitoring device (100) for the electric motor drive system according to claim 10 or 11, wherein the monitoring device computes torque of the AC electric motor (1) on the basis of a mathematical model of the electric motor drive system, calculates a state amount of the electric motor drive system by using the DC amount and a computation value of the torque, and extracts the feature amount on the basis of the state amount.

19. The monitoring device (100) for the electric motor drive system according to claim 10 or 11, wherein on the basis of the DC amount and an operating state of a switching element of a back-calculated inverter, the monitoring device extracts the feature amount of the switching element.

20. The monitoring device (100) for the electric motor drive system according to claim 8, wherein the monitoring device individually calculates respective operating states of the plurality of AC electric motors (1) on the basis of at least one of the phase and amplitude of currents flowing through the plurality of AC electric motors, and extracts the feature amount on the basis of the operating states.

21. The monitoring device (100) for the electric motor drive system according to claim 1,
wherein the monitoring device includes a controller (24) and a feature extractor (6) which outputs the feature amount,
wherein the controller and the feature extractor are operated on another signal processing device,
wherein the controller outputs a control internal state amount on rotating coordinate axes synchronized with an AC voltage output by the drive power supply, and
wherein the feature extractor extracts the feature amount with the control internal state amount as the DC amount.

22. The monitoring device (100) for the electric motor drive system according to claim 1,
wherein the monitoring device includes a controller (24) and a feature extractor (6) which outputs the feature amount,
wherein the controller and the feature extractor are operated on a signal processing device integrated therewith,
wherein at least either a current value on the rotating coordinate axes or a voltage value on the rotating coordinate axes used in the controller is utilized as the DC amount, and
wherein the feature extractor extracts the feature amount on the basis of at least one of the DC amount based on either the current value or the voltage value, and a rotational speed used in the controller.

23. The monitoring device (100) for the electric motor drive system according to claim 21 or 22,
wherein the controller (24) includes means determining an axial error being a difference between a rotor phase angle of the AC electric motor and an actual phase angle of the AC electric motor, and
wherein the feature extractor (6) extracts the feature amount on the basis of the axial error.

24. The monitoring device (100) for the electric motor drive system according to claim 21 or 22,
wherein the controller (24) includes means determining at least one state amount of an estimated amount of a driving speed of the AC electric motor, an estimated amount of a slip frequency of the AC electric motor, and an estimated amount of a magnetic flux generated inside the AC electric motor, and
wherein the feature extractor (6) extracts the feature amount on the basis of the state amount.

25. The monitoring device (100) for the electric motor drive system according to claim 21 or 22,
wherein the controller (24) operates in such a manner that a current command value on the rotating coordinate axes of the AC electric motor, and an actual current detection value coincide, and analyzes at least one of a current deviation being a deviation between the command value and the detection value, a state amount proportional to the current deviation, a state amount obtained by integrating the current deviation, and a state amount obtained by differentiating the current deviation, and
wherein the feature extractor (6) extracts the feature amount on the basis of at least one of the current deviation and the state amount.

26. The monitoring device (100) for the electric motor drive system according to any one of claims 1 to 25, wherein the feature amount indicates a temporal change or an abnormal operation of the AC electric motor (1); and, optionally,
wherein the feature amount is a feature amount related to at least one of the AC electric motor (1), the drive power supply connected to the AC electric motor, and a machine device connected to the AC electric motor.

27. An analysis system comprising:
the monitoring device (100) for an electric motor drive system according to any one of claims 1 to 26; and
the analysis/diagnosis device (8).

28. An industrial device system including the monitoring device (100) for an electric motor drive system according to any one of claims 1 to 26.

29. An automobile including the monitoring device (100) for an electric motor drive system according to any one of claims 1 to 26.

30. An electric railway vehicle including the monitoring device (100) for an electric motor drive system according to any one of claims 1 to 26.

31. An electric household appliance including the monitoring device (100) for an electric motor drive system according to any one of claims 1 to 26.

32. A monitoring method for an electric motor drive system, which monitors an AC electric motor (1) driven by a drive power supply (2) or a device connected to the AC electric motor, wherein the monitoring device (100):
converts a current detection value of at least two phases of the AC electric motor detected by current detecting means (4) of the AC electric motor into alternating currents of orthogonal two phases,
converts the alternating currents of the orthogonal two phases into a DC amount by performing coordinate conversion of the alternating currents of the orthogonal two phases, and
outputs the feature amount to an external analysis/diagnosis device (8), and
wherein the external analysis/diagnosis device analyzes a state of the AC electric motor or the device connected to the AC electric motor based on time-series data of the feature amount
**characterized in that**:
a coordinate conversion phase θI is determined by calculating an alternating current phase angle θi* between the alternating currents of the two orthogonal phases, and
the coordinate conversion of the orthogonal two phases is performed sing the determined coordinate conversion phase.

## Patentansprüche

1. Überwachungsvorrichtung (100) zum Einbau in einem Elektromotorantriebssystem, welches einen WS-Elektromotor (1) überwacht, der durch eine Antriebsleistungsversorgung (2) oder eine mit dem WS-Elektromotor verbundene Vorrichtung angetrieben wird,
wobei die Überwachungsvorrichtung für Folgendes ausgelegt ist:
Umwandeln eines Stromdetektionswerts von zumindest zwei Phasen des WS-Elektromotors, die durch Stromdetektionsmittel (4) des WS-Elektromotors detektiert werden, in Wechselströme von zwei orthogonalen Phasen,
Umwandeln der Wechselströme der zwei orthogonalen Phasen in ein GS-Ausmaß durch Durchführen einer Koordinatenumwandlung der Wechselströme der zwei orthogonalen Phasen,
Extrahieren eines Merkmalsausmaßes auf Basis des GS-Ausmaßes und
Ausgeben des Merkmalsausmaßes für eine externe Analyse-/Diagnosevorrichtung (8), welche einen Zustand des WS-Elektromotors oder der mit dem WS-Elektromotor verbundenen Vorrichtung basierend auf Zeit-Serien-Daten des Merkmalsausmaßes analysiert,
**dadurch gekennzeichnet, dass** die Vorrichtung ferner für Folgendes ausgelegt ist:
Bestimmen einer Koordinatenumwandlungsphase θi durch Berechnen eines Wechselstromphasenwinkels θi* zwischen den Wechselströmen der zwei orthogonalen Phasen und
Durchführen der Koordinatenumwandlung der Wechselströme der zwei orthogonalen Phasen unter Verwendung der bestimmten Koordinatenumwandlungsphase.

2. Überwachungsvorrichtung (100) nach Anspruch 1, wobei das Berechnen des Wechselstromphasenwinkels θi* Folgendes umfasst:
Verwenden eines Arkustangens-Rechners, um einen Wechselstromphasenwinkel θi* gemäß Folgendem zu berechnen: ${θ}_{i}^{∗} = {tan}^{- 1} \frac{{I}_{β}}{Iα}$
worin *I_{β}* und *I_{α}* die Wechselströme der zwei orthogonalen Phasen sind.

3. Überwachungsvorrichtung (100) nach Anspruch 2, wobei das Berechnen der Koordinatenumwandlungsphase ferner Folgendes umfasst:
Verwenden eines Phasenrechners 11, um die Koordinatenumwandlungsphase θi relativ zu dem Wechselstromphasenwinkel θi* durch Durchführen einer Proportional-Integral-Steuerung an einer Abweichung zwischen dem Wechselstromphasenwinkel θi* und der Koordinatenumwandlungsphase θi zu berechnen.

4. Überwachungsvorrichtung (100) nach Anspruch 3, wobei der Phasenberechnet 11 Folgendes umfasst:
einen Addierer 111, der dazu ausgelegt ist, die Abweichung zwischen dem Wechselstromphasenwinkel θi* und der Koordinatenumwandlungsphase θi zu berechnen, bei dem es sich um die Ausgabe des Phasenrechners 11 handelt;
eine PLL-Steuerung 112, welche die Proportional-Integral-Steuerung an der Abweichung durchführt und eine Winkelfrequenz wrs ausgibt; und
einen Integrator 113, der dazu ausgelegt ist, die Koordinatenumwandlungsphase θi durch Integrieren der Winkelfrequenz wrs zu berechnen.

5. Überwachungsvorrichtung (100) für ein Elektromotorantriebssystem nach Anspruch 1, wobei das Merkmalsausmaß über eine Kommunikationseinheit (7), welche durch ein drahtgebundenes oder drahtloses Kommunikationsnetzwerk konfiguriert ist, für die Analyse-/Diagnosevorrichtung (8) ausgegeben wird.

6. Überwachungsvorrichtung (100) für ein Elektromotorantriebssystem nach Anspruch 1, wobei das Merkmalsausmaß in einem Speicher (63) zum Ausgeben für die Analyse-/Diagnosevorrichtung gespeichert ist.

7. Überwachungsvorrichtung (100) für ein Elektromotorantriebssystem nach einem der Ansprüche 1 bis 5, wobei eine Vielzahl der WS-Elektromotoren (1) parallel mit einer Antriebsleistungsversorgung (2) verbunden sind und die Stromdetektionsmittel (4) einen Strom von jedem aus der Vielzahl von WS-Elektromotoren und/oder einen Ausgangsstrom der Antriebsleistungsversorgung detektieren.

8. Überwachungsvorrichtung (100) für ein Elektromotorsystem nach Anspruch 7, wobei, wenn die Vielzahl der WS-Elektromotoren (1) durch die eine Antriebsleistungsversorgung angetrieben wird, die Überwachungsvorrichtung die Stromdetektionswerte der Vielzahl von WS-Elektromotoren jeweils in die GS-Ausmaße umwandelt, indem sie eine gemeinsame Koordinatenumwandlungsphase θi und eine Winkelfrequenz wrs, welche aus einem Gesamtwert des durch die Antriebsstromversorgung zugeführten Stroms berechnet wird, verwendet.

9. Überwachungsvorrichtung (100) für ein Elektromotorantriebssystem nach Anspruch 1, wobei die Überwachungsvorrichtung den Stromdetektionswert auf Basis einer Position einer Drehwelle des WS-Elektromotors (1) oder einer Drehzahl desselben, die durch Drehwellenmessmittel (14) des WS-Elektromotors detektiert werden, in das GS-Ausmaß umwandelt.

10. Überwachungsvorrichtung (100) für ein Elektromotorantriebssystem nach Anspruch 1, wobei die Überwachungsvorrichtung den Stromdetektionswert auf Basis einer Spannung, die durch Spannungsdetektionsmittel (16), welche eine an den WS-Elektromotor (1) angelegte Spannung detektieren, detektiert wird, in das GS-Ausmaß umwandelt.

11. Überwachungsvorrichtung (100) für ein Elektromotorantriebssystem nach Anspruch 1, wobei die Überwachungsvorrichtung den Stromdetektionswert auf Basis von Phaseninformationen der Antriebsleistungsversorgung in das GS-Ausmaß umwandelt, wobei die Phaseninformationen durch eine interne Phase der Antriebsleistungsversorgung gebildet sind, die zur Vektorsteuerung des WS-Elektromotors verwendet wird.

12. Überwachungsvorrichtung (100) für ein Elektromotorantriebssystem nach einem der Ansprüche 1 bis 11, wobei die Überwachungsvorrichtung einen oder mehrere Filter verwendet, um eine Schwingungskomponente, die im Stromdetektionswert enthalten ist, zu extrahieren und die Schwingungskomponente als einen Wert des GS-Ausmaßes auszugeben und das Merkmalsausmaß auf Basis der Schwingungskomponente zu extrahieren.

13. Überwachungsvorrichtung (100) für ein Elektromotorantriebssystem nach einem der Ansprüche 1 bis 11, wobei unter Verwendung einer Frequenz, die beim Umwandeln des Stromdetektionswerts in das GS-Ausmaß verwendet wird, die Überwachungsvorrichtung eine pulsierende Komponente, die im Stromdetektionswert in einer ganzzahligen Ordnung oder einer Bruchordnung enthalten ist, frequenzanalysiert und das Merkmalsausmaß auf Basis eines Ergebnisses der Frequenzanalyse extrahiert.

14. Überwachungsvorrichtung (100) für ein Elektromotorantriebssystem nach einem der Ansprüche 1 bis 11, wobei sich das GS-Ausmaß über einen Bereich eines vorbestimmten Werts hinaus ändert, die Überwachungsvorrichtung zumindest eines aus einem Variationsausmaß im GS-Ausmaß und einem Variationsausmaß einer Frequenz, die beim Umwandeln des Stromdetektionswerts in das GS-Ausmaß verwendet wird, analysiert und das Merkmalsausmaß auf Basis eines Ergebnisses der Analyse extrahiert.

15. Überwachungsvorrichtung (100) für ein Elektromotorantriebssystem nach einem der Ansprüche 1 bis 11, wobei, wenn die Frequenz, die beim Umwandeln des Stromdetektionswerts in das GS-Ausmaß verwendet wird, sich über einen vorbestimmten Bereich hinaus ändert, die Überwachungsvorrichtung zumindest eines aus einem Variationsausmaß einer Frequenz und einem Ausmaß einer Variation des GS-Ausmaßes analysiert und das Merkmalsausmaß auf Basis eines Ergebnisses der Analyse extrahiert.

16. Überwachungsvorrichtung (100) für ein Elektromotorantriebssystem nach einem der Ansprüche 1 bis 11,
wobei zumindest eine Art von externem Sensor für Schwingung, Druck, Lärm, Temperatur oder Feuchtigkeit an dem Elektromotorantriebssystem befestigt ist und
wobei die Überwachungsvorrichtung eine Korrelation zwischen Informationen von der zumindest einen Art von externem Sensor und dem GS-Ausmaß analysiert und das Merkmalsausmaß auf Basis eines Ergebnisses der Analyse extrahiert.

17. Überwachungsvorrichtung (100) für ein Elektromotorsystem nach Anspruch 10 oder 11, wobei die Überwachungsvorrichtung zumindest eines aus momentaner Wirkleistung und momentaner Blindleistung auf Basis des GS-Ausmaßes berechnet und das Merkmalsausmaß auf Basis eines Ergebnisses der Analyse extrahiert.

18. Überwachungsvorrichtung (100) für ein Elektromotorantriebssystem nach Anspruch 10 oder 11, wobei die Überwachungsvorrichtung ein Drehmoment des WS-Elektromotors (1) auf Basis eines mathematischen Modells des Elektromotorantriebssystems errechnet, ein Zustandsausmaß des Elektromotorantriebssystems unter Verwendung des GS-Ausmaßes und einen Rechenwert des Drehmoments berechnet und das Merkmalsausmaß auf Basis des Zustandsausmaßes extrahiert.

19. Überwachungsvorrichtung (100) für ein Elektromotorantriebssystem nach Anspruch 10 oder 11, wobei die Überwachungsvorrichtung auf Basis des GS-Ausmaßes und eines Betriebszustands eines Schaltelements eines rückgerechneten Wechselrichters das Merkmalsausmaß des Schaltelements extrahiert.

20. Überwachungsvorrichtung (100) für ein Elektromotorsystem nach Anspruch 8, wobei die Überwachungsvorrichtung entsprechende Betriebszustände der Vielzahl von WS-Elektromotoren (1) auf Basis von zumindest einem aus der Phase und der Amplitude von Strömen, die durch die Vielzahl von WS-Elektromotoren fließen, individuell berechnet und das Merkmalsausmaß auf Basis der Betriebszustände extrahiert.

21. Überwachungsvorrichtung (100) für ein Elektromotorantriebssystem nach Anspruch 1,
wobei die Überwachungsvorrichtung eine Steuerung (24) und einen Merkmalsextraktor (6), welcher das Merkmalsausmaß ausgibt, umfasst,
wobei die Steuerung und der Merkmalsextraktor auf einer anderen Signalverarbeitungsvorrichtung betrieben werden,
wobei die Steuerung ein internes Steuerzustandsausmaß an Drehkoordinatenachsen synchronisiert mit einer WS-Spannungsausgabe durch die Antriebsleistungsversorgung ausgibt und
wobei der Merkmalsextraktor das Merkmalsausmaß mit dem internen Steuerzustandsausmaß als das GS-Ausmaß extrahiert.

22. Überwachungsvorrichtung (100) für ein Elektromotorantriebssystem nach Anspruch 1,
wobei die Überwachungsvorrichtung eine Steuerung (24) und einen Merkmalsextraktor (6), welcher das Merkmalsausmaß ausgibt, umfasst,
wobei die Steuerung und der Merkmalsextraktor auf einer mit diesen integrierten Signalverarbeitungsvorrichtung betrieben werden,
wobei zumindest entweder ein Stromwert an den Drehkoordinatenachsen oder ein Spannungswert an den Drehkoordinatenachsen, der in der Steuerung verwendet wird, als das GS-Ausmaß verwendet wird, und
wobei der Merkmalsextraktor das Merkmalsausmaß auf Basis von zumindest einem aus dem GS-Ausmaß, basierend auf entweder dem Stromwert oder dem Spannungswert, und einer in der Steuerung verwendeten Drehgeschwindigkeit extrahiert.

23. Überwachungsvorrichtung (100) für ein Elektromotorantriebssystem nach Anspruch 21 oder 22,
wobei die Steuerung (24) Mittel zum Bestimmen eines axialen Fehlers umfasst, der eine Differenz zwischen einem Rotorphasenwinkel des WS-Elektromotors und einem Ist-Phasenwinkel des WS-Elektromotors ist, und
wobei der Merkmalsextraktor (6) das Merkmalsausmaß auf Basis des axialen Fehlers extrahiert.

24. Überwachungsvorrichtung (100) für ein Elektromotorantriebssystem nach Anspruch 21 oder 22,
wobei die Steuerung (24) Mittel zum Bestimmen von zumindest einem Zustandsausmaß eines geschätzten Ausmaßes einer Antriebsgeschwindigkeit des WS-Elektromotors, eines geschätzten Ausmaßes einer Schlupffrequenz des WS-Elektromotors und eines geschätzten Ausmaßes eines Magnetflusses, der innerhalb des WS-Elektromotors erzeugt wird, umfasst, und
wobei der Merkmalsextraktor (6) das Merkmalsausmaß auf Basis des Zustandsausmaßes extrahiert.

25. Überwachungsvorrichtung (100) für ein Elektromotorantriebssystem nach Anspruch 21 oder 22,
wobei die Steuerung (24) derart arbeitet, dass ein Strombefehlswert an den Drehkoordinatenachsen des WS-Elektromotors und ein Ist-Strom-Detektionswert übereinstimmen, und zumindest eines aus einer Stromabweichung, die eine Abweichung zwischen dem Befehlswert und dem Detektionswert ist, einem Zustandsausmaß proportional zur Stromabweichung, einem Zustandsausmaß, das durch Integrieren der Stromabweichung erhalten wird, und einem Zustandsausmaß, das durch Differenzieren der Stromabweichung erhalten wird, analysiert und
wobei der Merkmalsextraktor (6) ein Merkmalsausmaß auf Basis von zumindest einem aus der Stromabweichung und dem Zustandsausmaß extrahiert.

26. Überwachungsvorrichtung (100) für ein Elektromotorantriebssystem nach einem der Ansprüche 1 bis 25, wobei das Merkmalsausmaß eine zeitliche Änderung oder einen anormalen Betrieb des WS-Elektromotors (1) anzeigt; und gegebenenfalls
wobei das Merkmalsausmaß ein Merkmalsausmaß in Verbindung mit zumindest einem aus dem WS-Elektromotor (1), der mit dem WS-Elektromotor verbundenen Antriebsleistungsversorgung und einer mit dem WS-Elektromotor verbundenen Maschinenvorrichtung ist.

27. Analysesystem, umfassend:
eine Überwachungsvorrichtung (100) für ein Elektromotorantriebssystem nach einem der Ansprüche 1 bis 26; und
die Analyse-/Diagnosevorrichtung (8).

28. Industrielles Vorrichtungssystem, umfassend eine Überwachungsvorrichtung (100) für ein Elektromotorantriebssystem nach einem der Ansprüche 1 bis 26.

29. Auto, das eine Überwachungsvorrichtung (100) für ein Elektromotorantriebssystem nach einem der Ansprüche 1 bis 26 umfasst.

30. Elektrisches Schienenfahrzeug, das eine Überwachungsvorrichtung (100) für ein Elektromotorantriebssystem nach einem der Ansprüche 1 bis 26 umfasst.

31. Elektrisches Haushaltsgerät, das eine Überwachungsvorrichtung (100) für ein Elektromotorantriebssystem nach einem der Ansprüche 1 bis 26 umfasst.

32. Überwachungsverfahren für ein Elektromotorantriebssystem, welches einen WS-Elektromotor (1) überwacht, der durch eine Antriebsleistungsversorgung (2) oder eine mit dem WS-Elektromotor verbundene Vorrichtung angetrieben wird, wobei die Überwachungsvorrichtung (100):
einen Stromdetektionswert von zumindest zwei Phasen des WS-Elektromotors, die durch Stromdetektionsmittel (4) des WS-Elektromotors detektiert werden, in Wechselströme von zwei orthogonalen Phasen umwandelt,
die Wechselströme der zwei orthogonalen Phasen durch Durchführen einer Koordinatenumwandlung der Wechselströme der zwei orthogonalen Phasen in ein GS-Ausmaß umwandelt, und
das Merkmalsausmaß für eine externe Analyse-/Diagnosevorrichtung (8) ausgibt, und
wobei die externe Analyse-/Diagnosevorrichtung einen Zustand des WS-Elektromotors oder der mit dem WS-Elektromotor verbundenen Vorrichtung basierend auf Zeit-Serien-Daten des Merkmalsausmaßes analysiert,
**dadurch gekennzeichnet, dass**:
eine Koordinatenumwandlungsphase θi durch Berechnen eines Wechselstromphasenwinkels θi* zwischen den Wechselströmen der zwei orthogonalen Phasen bestimmt wird, und
die Koordinatenumwandlung der Wechselströme der zwei orthogonalen Phasen unter Verwendung der bestimmten Koordinatenumwandlungsphase durchgeführt wird.

## Revendications

1. Dispositif de surveillance (100) destiné à être installé dans un système d'entraînement à moteur électrique, qui surveille un moteur électrique à courant alternatif CA, (1) entraîné par une alimentation électrique d'entraînement (2) ou un dispositif connecté au moteur électrique CA,
dans lequel le dispositif de surveillance est configuré pour :
convertir une valeur de détection de courant d'au moins deux phases du moteur électrique CA détectée par des moyens de détection de courant (4) du moteur électrique CA en courants alternatifs de deux phases orthogonales,
convertir les courants alternatifs des deux phases orthogonales en une quantité de courant continu, CC, en effectuant une conversion de coordonnées des courants alternatifs des deux phases orthogonales,
extraire une quantité caractéristique sur la base de la quantité de CC, et
délivrer en sortie la quantité caractéristique à un dispositif d'analyse/de diagnostic externe (8) qui analyse un état du moteur électrique CA ou du dispositif connecté au moteur électrique CA sur la base de données de série temporelle de la quantité caractéristique,
**caractérisé en ce que** le dispositif est en outre configuré pour :
déterminer une phase de conversion de coordonnées θi en calculant un angle de phase de courant alternatif θi* entre les courants alternatifs des deux phases orthogonales, et
effectuer la conversion de coordonnées des courants alternatifs des deux phases orthogonales en utilisant la phase de conversion de coordonnées déterminée.

2. Dispositif de surveillance (100) selon la revendication 1, dans lequel le calcul de l'angle de phase de courant alternatif θi* comprend l'étape consistant à :
utiliser un calculateur d'arctangente pour calculer un angle de phase de courant alternatif θi* selon : ${θ}_{i}^{∗} = {tan}^{- 1} \frac{{I}_{β}}{{I}_{α}}$
dans lequel *I_{β}* et *I_{α}* sont les courants alternatifs des deux phases orthogonales.

3. Dispositif de surveillance (100) selon la revendication 2, dans lequel le calcul de la phase de conversion de coordonnées comprend en outre l'étape consistant à :
utiliser un calculateur de phase 11 pour calculer la phase de conversion de coordonnées θi par rapport à l'angle de phase de courant alternatif θi* en effectuant une commande intégrale proportionnelle sur un écart entre l'angle de phase de courant alternatif θi* et la phase de conversion de coordonnées θi.

4. Dispositif de surveillance (100) selon la revendication 3, dans lequel le calculateur de phase 11 comprend :
un additionneur 111 configuré pour calculer l'écart entre l'angle de phase de courant alternatif θi* et la phase de conversion de coordonnées θi étant la sortie du calculateur de phase 11 ;
un dispositif de commande PLL 112 qui effectue la commande intégrale proportionnelle sur l'écart et délivre en sortie une fréquence angulaire ωrs ; et
un intégrateur 113 configuré pour calculer la phase de conversion de coordonnées θi en intégrant la fréquence angulaire ωrs.

5. Dispositif de surveillance (100) pour le système d'entraînement à moteur électrique selon la revendication 1, dans lequel la quantité caractéristique est délivrée en sortie au dispositif d'analyse/de diagnostic (8) via une unité de communication (7) configurée par un réseau de communication filaire ou sans fil.

6. Dispositif de surveillance (100) pour le système d'entraînement à moteur électrique selon la revendication 1, dans lequel la quantité caractéristiques est stockée dans une mémoire (63) pour une sortie vers le dispositif d'analyse/de diagnostic.

7. Dispositif de surveillance (100) pour le système d'entraînement à moteur électrique selon l'une quelconque des revendications 1 à 5, dans lequel une pluralité de moteurs électriques CA (1) sont connectés en parallèle à une alimentation électrique d'entraînement (2), et les moyens de détection de courant (4) détectent un courant de chacun de la pluralité de moteurs électriques CA et/ou un courant de sortie de l'alimentation électrique d'entraînement.

8. Dispositif de surveillance (100) pour le système d'entraînement à moteur électrique selon la revendication 7, dans lequel lorsque la pluralité des moteurs électriques CA (1) sont entraînés par la première alimentation électrique d'entraînement, le dispositif de surveillance convertit les valeurs de détection de courant de la pluralité de moteurs électriques CA en les quantités de CC respectivement en utilisant une phase de conversion de coordonnées commune θi et une fréquence angulaire ωrs calculée à partir d'une valeur totale du courant fourni par l'alimentation électrique d'entraînement.

9. Dispositif de surveillance (100) pour le système d'entraînement à moteur électrique selon la revendication 1, dans lequel le dispositif de surveillance convertit la valeur de détection de courant en la quantité de CC sur la base d'une position d'un arbre de rotation du moteur électrique CA (1) ou d'une vitesse de celui-ci détectée par des moyens de mesure d'arbre de rotation (14) du moteur électrique CA.

10. Dispositif de surveillance (100) pour le système d'entraînement à moteur électrique selon la revendication 1, dans lequel le dispositif de surveillance convertit la valeur de détection de courant en la quantité de CC sur la base d'une tension détectée par des moyens de détection de tension (16) détectant une tension appliquée au moteur électrique CA (1).

11. Dispositif de surveillance (100) pour le système d'entraînement à moteur électrique selon la revendication 1, dans lequel le dispositif de surveillance convertit la valeur de détection de courant en la quantité de CC sur la base d'informations de phase de l'alimentation électrique d'entraînement, les informations de phase étant une phase interne de l'alimentation électrique d'entraînement utilisée pour la commande vectorielle du moteur électrique CA.

12. Dispositif de surveillance (100) pour le système d'entraînement à moteur électrique selon l'une quelconque des revendications 1 à 11, dans lequel le dispositif de surveillance utilise un ou plusieurs filtres pour extraire une composante de vibration contenue dans la valeur de détection de courant et délivrer en sortie la composante de vibration en tant que valeur de la quantité de CC et extraire la quantité caractéristique sur la base de la composante de vibration.

13. Dispositif de surveillance (100) pour le système d'entraînement à moteur électrique selon l'une quelconque des revendications 1 à 11, dans lequel en utilisant une fréquence utilisée lors de la conversion de la valeur de détection de courant en la quantité de CC, le dispositif de surveillance analyse en fréquence une composante pulsée contenue dans la valeur de détection de courant selon un ordre entier ou un ordre de fraction et extrait la quantité caractéristique sur la base d'un résultat de l'analyse en fréquence.

14. Dispositif de surveillance (100) pour le système d'entraînement à moteur électrique selon l'une quelconque des revendications 1 à 11, dans lequel lorsque la quantité de CC change au-delà d'une plage d'une valeur prédéterminée, le dispositif de surveillance analyse au moins une parmi une quantité de variation de la quantité de CC et une quantité de variation d'une fréquence utilisée lors de la conversion de la valeur de détection de courant en la quantité de CC et extrait la quantité caractéristique sur la base d'un résultat de l'analyse.

15. Dispositif de surveillance (100) pour le système d'entraînement à moteur électrique selon l'une quelconque des revendications 1 à 11, dans lequel lorsque la fréquence utilisée lors de la conversion de la valeur de détection de courant en la quantité de CC change au-delà d'une plage prédéterminée, le dispositif de surveillance analyse au moins l'une d'une quantité de variation d'une fréquence et d'une quantité de variation de la quantité de CC et extrait la quantité caractéristique sur la base d'un résultat de l'analyse.

16. Dispositif de surveillance (100) pour le système d'entraînement à moteur électrique selon l'une quelconque des revendications 1 à 11,
dans lequel au moins un type de capteur externe de vibration, de pression, de bruit, de température ou d'humidité est fixé au système d'entraînement à moteur électrique, et
dans lequel le dispositif de surveillance analyse une corrélation entre des informations provenant du au moins un type d'informations de capteur externe et la quantité de CC et extrait la quantité caractéristique sur la base d'un résultat de l'analyse.

17. Dispositif de surveillance (100) pour le système d'entraînement à moteur électrique selon la revendication 10 ou 11, dans lequel le dispositif de surveillance calcule au moins l'une d'une puissance active instantanée et d'une puissance réactive instantanée sur la base de la quantité de CC et extrait la quantité caractéristique sur la base d'un résultat du calcul.

18. Dispositif de surveillance (100) pour le système d'entraînement à moteur électrique selon la revendication 10 ou 11, dans lequel le dispositif de surveillance calcule le couple du moteur électrique CA (1) sur la base d'un modèle mathématique du système d'entraînement à moteur électrique, calcule une quantité d'état du système d'entraînement à moteur électrique en utilisant la quantité de CC et une valeur de calcul du couple, et extrait la quantité caractéristique sur la base de la quantité d'état.

19. Dispositif de surveillance (100) pour le système d'entraînement à moteur électrique selon la revendication 10 ou 11, dans lequel sur la base de la quantité de CC et d'un état de fonctionnement d'un élément de commutation d'un onduleur recalculé, le dispositif de surveillance extrait la quantité caractéristique de l'élément de commutation.

20. Dispositif de surveillance (100) pour le système d'entraînement à moteur électrique selon la revendication 8, dans lequel le dispositif de surveillance calcule individuellement des états de fonctionnement respectifs de la pluralité de moteurs électriques CA (1) sur la base d'au moins l'une de la phase et de l'amplitude de courants circulant à travers la pluralité de moteurs électriques CA, et extrait la quantité caractéristique sur la base des états de fonctionnement.

21. Dispositif de surveillance (100) pour le système d'entraînement à moteur électrique selon la revendication 1,
dans lequel le dispositif de surveillance comprend un dispositif de commande (24) et un extracteur de caractéristique (6) qui délivre en sortie la quantité caractéristique,
dans lequel le dispositif de commande et l'extracteur de caractéristique sont actionnés sur un autre dispositif de traitement de signal,
dans lequel le dispositif de commande délivre en sortie une quantité d'état interne de commande sur des axes de coordonnées de rotation synchronisés avec une tension CA délivrée en sortie par l'alimentation électrique d'entraînement, et
dans lequel l'extracteur de caractéristique extrait la quantité caractéristique avec la quantité d'état interne de commande en tant que quantité de CC.

22. Dispositif de surveillance (100) pour le système d'entraînement à moteur électrique selon la revendication 1,
dans lequel le dispositif de surveillance comprend un dispositif de commande (24) et un extracteur de caractéristique (6) qui délivre en sortie la quantité caractéristique,
dans lequel le dispositif de commande et l'extracteur de caractéristique sont actionnés sur un dispositif de traitement de signal intégré à ceux-ci,
dans lequel au moins une valeur de courant sur les axes de coordonnées de rotation ou une valeur de tension sur les axes de coordonnées de rotation utilisés dans le dispositif de commande est utilisée comme quantité de CC, et
dans lequel l'extracteur de caractéristique extrait la quantité caractéristique sur la base d'au moins une parmi la quantité de CC sur la base soit de la valeur actuelle soit de la valeur de tension, et une vitesse de rotation utilisée dans le dispositif de commande.

23. Dispositif de surveillance (100) pour le système d'entraînement à moteur électrique selon la revendication 21 ou 22,
dans lequel le dispositif de commande (24) comprend des moyens déterminant une erreur axiale qui est une différence entre un angle de phase de rotor du moteur électrique CA et un angle de phase réel du moteur électrique CA, et
dans lequel l'extracteur de caractéristique (6) extrait la quantité de caractéristique sur la base de l'erreur axiale.

24. Dispositif de surveillance (100) pour le système d'entraînement à moteur électrique selon la revendication 21 ou 22,
dans lequel le dispositif de commande (24) comprend des moyens déterminant au moins une quantité d'état d'une quantité estimée d'une vitesse d'entraînement du moteur électrique CA, une quantité estimée d'une fréquence de glissement du moteur électrique CA, et une quantité estimée d'un flux magnétique généré à l'intérieur du moteur électrique CA, et
dans lequel l'extracteur de caractéristique (6) extrait la quantité caractéristique sur la base de la quantité d'état.

25. Dispositif de surveillance (100) pour le système d'entraînement à moteur électrique selon la revendication 21 ou 22,
dans lequel le dispositif de commande (24) fonctionne de manière à ce qu'une valeur d'instruction de courant sur les axes de coordonnées de rotation du moteur électrique CA, et une valeur de détection de courant réelle coïncident, et analyse au moins l'un d'un écart de courant étant un écart entre la valeur d'instruction et la valeur de détection, une quantité d'état proportionnelle à l'écart de courant, une quantité d'état obtenue en intégrant l'écart de courant, et une quantité d'état obtenue en différenciant l'écart de courant, et
dans lequel l'extracteur de caractéristique (6) extrait la quantité de caractéristique sur la base d'au moins l'un de l'écart de courant et de la quantité d'état.

26. Dispositif de surveillance (100) pour le système d'entraînement à moteur électrique selon l'une quelconque des revendications 1 à 25, dans lequel la quantité caractéristique indique un changement temporel ou un fonctionnement anormal du moteur électrique CA (1) ; et, facultativement,
dans lequel la quantité caractéristique est une quantité caractéristique liée à au moins l'un du moteur électrique CA (1), de l'alimentation électrique d'entraînement connectée au moteur électrique CA, et d'un dispositif de machine connecté au moteur électrique CA.

27. Système d'analyse, comprenant :
le dispositif de surveillance (100) pour un système d'entraînement à moteur électrique selon l'une quelconque des revendications 1 à 26 ; et
le dispositif d'analyse/de diagnostic (8).

28. Système de dispositif industriel comprenant le dispositif de surveillance (100) pour un système d'entraînement à moteur électrique selon l'une quelconque des revendications 1 à 26.

29. Véhicule automobile comprenant le dispositif de surveillance (100) pour un système d'entraînement à moteur électrique selon l'une quelconque des revendications 1 à 26.

30. Véhicule ferroviaire électrique comprenant le dispositif de surveillance (100) pour un système d'entraînement à moteur électrique selon l'une quelconque des revendications 1 à 26.

31. Appareil électroménager comprenant le dispositif de surveillance (100) pour un système d'entraînement à moteur électrique selon l'une quelconque des revendications 1 à 26.

32. Procédé de surveillance pour un système d'entraînement à moteur électrique, qui surveille un moteur électrique CA (1) entraîné par une alimentation électrique d'entraînement (2) ou un dispositif connecté au moteur électrique CA, dans lequel le dispositif de surveillance (100) :
convertit une valeur de détection de courant d'au moins deux phases du moteur électrique CA détectée par des moyens de détection de courant (4) du moteur électrique CA en courants alternatifs de deux phases orthogonales,
convertit les courants alternatifs des deux phases orthogonales en une quantité de CC en effectuant une conversion de coordonnées des courants alternatifs des deux phases orthogonales, et
délivre en sortie la quantité caractéristique à un dispositif d'analyse/de diagnostic externe (8), et
dans lequel le dispositif d'analyse/de diagnostic externe analyse un état du moteur électrique CA ou du dispositif connecté au moteur électrique CA sur la base de données de série temporelle de la quantité caractéristique
**caractérisé en ce que** :
une phase de conversion de coordonnées θi est déterminée en calculant un angle de phase de courant alternatif θi* entre les courants alternatifs des deux phases orthogonales, et
la conversion de coordonnées des deux phases orthogonales est effectuée à partir de la phase de conversion de coordonnées déterminée.
